(19)

**Europäisches Patentamt**
**European Patent Office**
**Office européen des brevets**

(11) **EP 4 523 943 A1**

(12) **EUROPEAN PATENT APPLICATION**

(43) Date of publication:
19.03.2025 Bulletin 2025/12

(21) Application number: 24192939.7

(22) Date of filing: 05.08.2024

(51) International Patent Classification (IPC):
*B60L 3/00* (2019.01)     *B60L 3/12* (2006.01)
*B60L 53/10* (2019.01)    *B60L 58/12* (2019.01)
*B60L 58/16* (2019.01)    *B60W 50/04* (2006.01)
*G01R 31/387* (2019.01)   *G01R 31/392* (2019.01)
*H01M 10/48* (2006.01)    *H01M 10/625* (2014.01)
*H02J 7/00* (2006.01)

(52) Cooperative Patent Classification (CPC):
**B60L 58/12; B60L 3/0046; B60L 3/12; B60L 53/11;**
**B60L 58/16; B60W 50/045; G01R 31/387;**
**G01R 31/392; H01M 10/486; H01M 10/625;**
**H02J 7/0048; H02J 7/005;** B60L 2240/16;
B60L 2240/545; B60L 2240/549;          (Cont.)

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: 18.09.2023 KR 20230124150

(71) Applicants:
• **Hyundai Motor Company**
  **Seoul 06797 (KR)**
• **Kia Corporation**
  **Seocho-gu**
  **Seoul 06797 (KR)**

(72) Inventors:
• **JUNG, Dae Hyun**
  **18280 Hwaseong-si (KR)**
• **JANG, Hyun Jun**
  **18280 Hwaseong-si (KR)**

• **SEO, Kang Seob**
  **18280 Hwaseong-si (KR)**
• **PARK, Min Jun**
  **18280 Hwaseong-si (KR)**
• **KIM, Woo Sung**
  **18280 Hwaseong-si (KR)**
• **PARK, Byung Soo**
  **18280 Hwaseong-si (KR)**

(74) Representative: **Isarpatent**
**Patent- und Rechtsanwälte**
**Barth Hassa Peckmann & Partner mbB**
**Friedrichstraße 31**
**80801 München (DE)**

Remarks:
A request for correction of the description page 19
has been filed pursuant to Rule 139 EPC. A decision
on the request will be taken during the proceedings
before the Examining Division (Guidelines for
Examination in the EPO, A-V, 3.).

(54) **VEHICLE BATTERY CONTROL APPARATUS AND METHOD THEREOF**

(57)     A vehicle battery control apparatus (100) which
includes a memory (120) and a controller (130). For
example, the vehicle battery control apparatus (100)
obtains at least one of driving durability data according
to a driving state of a host vehicle or calendar aging data
according to a parking state of the host vehicle, or any
combination thereof, obtains degradation data of a battery of the host vehicle using at least some of the driving
durability data or the calendar aging data, or the any
combination thereof, and compares reference data iden-
tified based on a predetermined reference model with the
degradation data to determine a degradation state of the
battery.

```
VEHICLE BATTERY CONTROL APPARATUS
                100
┌──────────────────────────────────┐
│            MEMORY                  │
│             120                    │
└──────────────────────────────────┘
┌──────────────────────────────────┐
│           CONTROLLER               │
│             130                    │
└──────────────────────────────────┘
┌──────────────────────────────────┐
│            DISPLAY                 │
│             140                    │
└──────────────────────────────────┘
```

FIG.1

EP 4 523 943 A1

(52) Cooperative Patent Classification (CPC): (Cont.)
B60L 2240/80; B60L 2250/12; B60L 2250/16;
H01M 2220/20; H02J 2310/48

**Description**

**BACKGROUND OF THE PRESENT DISCLOSURE**

**Field of the Present Disclosure**

The present disclosure relates to a vehicle battery control apparatus and a method thereof, and more particularly, relates to technologies of identifying a degradation state of a battery included in a vehicle and providing a user with the identified result.

**Description of Related art**

As environmental issues and energy resource issues become more important, electric vehicles are one of the types of vehicles being spotlighted as future eco-friendly transportation means among the transportation means provided to solve these issues. Herein, the electric vehicle utilizes a battery with relatively higher cost than other portions as a power supply source.

Thus, considering that the burden in terms of cost is relatively large, efficient management and use of the battery is necessary. From the present perspective, various technologies have been developed through many recent studies for efficient use of the battery in the electric vehicle. A technology for providing a user of the electric vehicle with battery information including degradation data (e.g., a state of health (SOH)) of the battery may be applied to mass-produced electric vehicles.

Meanwhile, a technology for identifying data about the use of the battery of the electric vehicle in real time, immediately determining a degradation degree based on the identified result, and providing feedback on the determined result is insufficient. Thus, there is a need to develop a technology for feeding back information related to a degradation degree of the battery to a user in real time based on driving data.

The information included in this Background of the present disclosure is only for enhancement of understanding of the general background of the present disclosure and may not be taken as an acknowledgement or any form of suggestion that this information forms the prior art already known to a person skilled in the art.

**BRIEF SUMMARY**

Various aspects of the present disclosure are directed to providing a vehicle battery control apparatus for obtaining driving information (or driving durability data) about the driving of a host vehicle in a situation in which the host vehicle is driving, identifying abandonment information (or calendar aging data) about the abandonment of the host vehicle in a situation in which the host vehicle is being abandoned (e.g., while parked in a state in which the host vehicle is powered off), and identifying degradation data of the battery using at least some of the pieces of identified information.

Another aspect of the present disclosure provides a vehicle battery control apparatus for identifying a reference durability model using various types of parameters predefined by an experiment and/or a study and displaying a degradation degree of the battery, which is identified based on the result of comparing the reference durability model with a real-time durability model to a user on a display.

Another aspect of the present disclosure provides a vehicle battery control apparatus for identifying a score value based on a degradation state of a battery and displaying different types of battery state notifications to the user depending on a magnitude of the score value.

Another aspect of the present disclosure provides a vehicle battery control apparatus for comparing at least one of a battery quick charge ratio, a normal driving ratio, an average battery capacity while parked, or an average battery temperature while driving, or any combination thereof with a predetermined threshold and displaying a battery management guide identified based on the compared result to the user.

Another aspect of the present disclosure provides a vehicle battery control apparatus for identifying a degradation degree of the battery based on a life prediction model (or a reference durability model) and displaying a battery state notification and/or a battery management guide corresponding to the identified degradation degree to the user.

The technical problems to be solved by the present disclosure are not limited to the aforementioned problems, and any other technical problems not mentioned herein will be clearly understood from the following description by those skilled in the art to which the present disclosure pertains.

According to an aspect of the present disclosure, the vehicle battery control apparatus may include a memory storing at least one instruction and a controller operatively connected to the memory. For example, the at least one instruction may be configured to, when executed by the controller, cause the vehicle battery control apparatus to obtain at least one of driving durability data according to a driving state of a host vehicle or calendar aging data according to a parking state of the host vehicle, or any combination thereof, obtain degradation data of a battery of the host vehicle using at least some of the driving durability data or the calendar aging data, or the any combination thereof, and compare reference data identified based on a predetermined reference model with the degradation data to determine a degradation state of the battery.

According to an exemplary embodiment of the present disclosure, the at least one instruction may be configured to, when executed by the controller, cause the vehicle battery control apparatus to accumulate and store the driving durability data according to the driving state while driving in the memory, when the host vehicle starts to drive, and identify the degradation data of the battery, based on at least one of the calendar aging data according to the parking state, the calendar aging data being stored in the memory before the host vehicle starts to drive, or an existing calendar aging model, or any combination thereof.

According to an exemplary embodiment of the present disclosure, the at least one instruction may be configured to, when executed by the controller, cause the vehicle battery control apparatus to identify the degradation data of the battery based on at least one of the existing calendar aging model corresponding to an abandonment time period before the host vehicle starts to drive or the calendar aging data, or any combination thereof and store a first calendar aging model determined using the calendar aging data, the degradation data, and the existing calendar aging model in the memory, upon concluding that an abandonment time before the host vehicle starts to drive is greater than a predetermined time, and determine and store the existing calendar aging model as the first calendar aging model in the memory, upon concluding that the abandonment time is less than or equal to the predetermined time.

According to an exemplary embodiment of the present disclosure, the calendar aging data may include at least one of an abandonment time until the host vehicle starts to drive, a state of charge (SOC) value of the battery at a time point when the host vehicle is abandoned, or a battery temperature at each of the time point when the host vehicle is abandoned and the time point when the host vehicle starts to drive, or any combination thereof.

According to an exemplary embodiment of the present disclosure, the at least one instruction may be configured to, when executed by the controller, cause the vehicle battery control apparatus to accumulate and store the calendar aging data according to the parking state during abandonment in the memory, when the host vehicle ends driving and is powered off, and identify the degradation data of the battery, based on at least one of the driving durability data according to the driving state, the driving durability data being stored in the memory before the host vehicle is powered off, or an existing driving durability model, or any combination thereof.

According to an exemplary embodiment of the present disclosure, the at least one instruction may be configured to, when executed by the controller, cause the vehicle battery control apparatus to identify the degradation data of the battery based on at least one of the existing driving durability model identified in a driving period before the host vehicle is powered off or the driving durability data, or any combination thereof and store a first driving durability model identified using the driving durability data, the degradation data, and the existing driving durability model in the memory, upon concluding that energy used while driving before the host vehicle is powered off is greater than a specified amount, and determine and store the existing driving durability model as the first driving durability model in the memory, upon concluding that the energy is less than or equal to the specified amount.

According to an exemplary embodiment of the present disclosure, the driving durability data may include at least one of energy used until the host vehicle is powered off, a current used while the host vehicle is driving, or an average battery temperature while the host vehicle is driving, or any combination thereof.

According to an exemplary embodiment of the present disclosure, the at least one instruction may be configured to, when executed by the controller, cause the vehicle battery control apparatus to determine the reference model based on reference durability data about at least one of a current, a temperature of the battery, or an SOC value, or any combination thereof, when the host vehicle ends driving and is powered off, and compare the reference data identified by inputting at least one of at least a portion of the driving durability data or at least a portion of the calendar aging data, or any combination thereof to the reference model with the degradation data to identify the degradation state of the battery.

According to an exemplary embodiment of the present disclosure, the vehicle battery control apparatus may further include a display. For example, the at least one instruction may be configured to, when executed by the controller, cause the vehicle battery control apparatus to identify a score about a degradation degree of the battery, based on a difference between the reference data and the degradation data, and display at least one of a predetermined battery state notification corresponding to a magnitude of the score among a plurality of battery state notifications or a battery operation guide identified based on a battery usage history, or any combination thereof, using the display.

According to an exemplary embodiment of the present disclosure, the at least one instruction may be configured to, when executed by the controller, cause the vehicle battery control apparatus to display the battery operation guide including at least one of a ratio between normal charge and quick charge, a ratio between normal driving and driving at rapid acceleration and deceleration, an amount of average charging of the battery while parked, or an average temperature of the battery while driving, or any combination thereof.

According to another aspect of the present disclosure, the vehicle battery control method may include obtaining, by a controller, at least one of driving durability data according to a driving state of a host vehicle or calendar aging data according to a parking state of the host vehicle, or any combination thereof, obtaining, by the controller, degradation data of a battery of the host vehicle using at least some of the driving durability data or the calendar aging data, or the any combination thereof, and comparing, by the controller, reference data identified based on a predetermined reference model with the degradation data to determine a degradation state of the battery.

According to an exemplary embodiment of the present disclosure, the identifying of the degradation data by the controller may include accumulating and storing, by the controller, the driving durability data according to the driving state while driving in a memory, when the host vehicle starts to drive, and identifying, by the controller, the degradation data of the battery, based on at least one of the calendar aging data according to the parking state, the calendar aging data being stored in the memory before the host vehicle starts to drive, or an existing calendar aging model, or any combination thereof.

According to an exemplary embodiment of the present disclosure, the vehicle battery control method may further include identifying, by the controller, the degradation data of the battery based on at least one of the existing calendar aging model corresponding to an abandonment time period before the host vehicle starts to drive or the calendar aging data, or any combination thereof and storing, by the controller, a first calendar aging model determined using the calendar aging data, the degradation data, and the existing calendar aging model in the memory, upon concluding that an abandonment time before the host vehicle starts to drive is greater than a predetermined time, and determining and storing, by the controller, the existing calendar aging model as the first calendar aging model in the memory, upon concluding that the abandonment time is less than or equal to the predetermined time.

According to an exemplary embodiment of the present disclosure, the calendar aging data may include at least one of an abandonment time until the host vehicle starts to drive, a state of charge (SOC) value of the battery at a time point when the host vehicle is abandoned, or a battery temperature at each of the time point when the host vehicle is abandoned and the time point when the host vehicle starts to drive, or any combination thereof.

According to an exemplary embodiment of the present disclosure, the identifying of the degradation data by the controller may include accumulating and storing, by the controller, the calendar aging data according to the parking state during abandonment in the memory, when the host vehicle ends driving and is powered off, and identifying the degradation data of the battery, based on at least one of the driving durability data according to the driving state, the driving durability data being stored in the memory before the host vehicle is powered off, an existing driving durability model, or any combination thereof.

According to an exemplary embodiment of the present disclosure, the vehicle battery control method may further include identifying the degradation data of the battery based on at least one of the existing driving durability model identified in a driving period before the host vehicle is powered off or the driving durability data, or any combination thereof and storing, by the controller, a first driving durability model identified using the driving durability data, the degradation data, and the existing driving durability model in the memory, upon concluding that energy used while driving before the host vehicle is powered off is greater than a specified amount, and determining and storing, by the controller, the existing driving durability model as the first driving durability model in the memory, upon concluding that the energy is less than or equal to the specified amount.

According to an exemplary embodiment of the present disclosure, the driving durability data may include at least one of energy used until the host vehicle is powered off, a current used while the host vehicle is driving, or an average battery temperature while the host vehicle is driving, or any combination thereof.

According to an exemplary embodiment of the present disclosure, the vehicle battery control method may further include determining, by the controller, the reference model based on reference durability data about at least one of a current, a temperature of the battery, or an SOC value, or any combination thereof, when the host vehicle ends driving and is powered off, and comparing, by the controller, the reference data identified by inputting at least one of at least a portion of the driving durability data or at least a portion of the calendar aging data, or any combination thereof to the reference model with the degradation data to identify the degradation state of the battery.

According to an exemplary embodiment of the present disclosure, the vehicle battery control method may further include identifying, by the controller, a score about a degradation degree of the battery, based on a difference between the reference data and the degradation data, and displaying, by the controller, at least one of a predetermined battery state notification corresponding to a magnitude of the score among a plurality of battery state notifications or a battery operation guide identified based on a battery usage history, or any combination thereof, using a display.

According to an exemplary embodiment of the present disclosure, the displaying of the battery operation guide by the controller may include displaying, by the controller, the battery operation guide including at least one of a ratio between normal charge and quick charge, a ratio between normal driving and driving at rapid acceleration and deceleration, an amount of average charging of the battery while parked, or an average temperature of the battery while driving, or any combination thereof.

The methods and apparatuses of the present disclosure have other features and advantages which will be apparent from or are set forth in more detail in the accompanying drawings, which are incorporated herein, and the following Detailed Description, which together serve to explain certain principles of the present disclosure.

## BRIEF DESCRIPTION OF THE DRAWINGS

FIG. 1 is a block diagram illustrating components of a vehicle battery control apparatus according to an exemplary embodiment of the present disclosure;

FIG. 2 is a block diagram illustrating components of a vehicle battery control apparatus according to an exemplary embodiment of the present disclosure;

FIG. 3 is a flowchart of a vehicle battery control method according to an exemplary embodiment of the present disclosure;

FIG. 4 is a drawing illustrating a user interface provided by a vehicle battery control apparatus according to an exemplary embodiment of the present disclosure;

FIG. 5 is a flowchart of a vehicle battery control method according to an exemplary embodiment of the present disclosure;

FIG. 6 is a flowchart of a vehicle battery control method according to an exemplary embodiment of the present disclosure;

FIG. 7 is a flowchart of a vehicle battery control method according to an exemplary embodiment of the present disclosure;

FIG. 8 is a flowchart of a vehicle battery control method according to an exemplary embodiment of the present disclosure;

FIG. 9 is a flowchart of a vehicle battery control method according to an exemplary embodiment of the present disclosure; and

FIG. 10 illustrates a computing system about a vehicle battery control method according to an exemplary embodiment of the present disclosure.

It may be understood that the appended drawings are not necessarily to scale, presenting a somewhat simplified representation of various features illustrative of the basic principles of the present disclosure. The specific design features of the present disclosure as included herein, including, for example, specific dimensions, orientations, locations, and shapes will be determined in part by the particularly intended application and use environment.

In the figures, reference numbers refer to the same or equivalent parts of the present disclosure throughout the several figures of the drawing.

## DETAILED DESCRIPTION

Reference will now be made in detail to various embodiments of the present disclosure(s), examples of which are illustrated in the accompanying drawings and described below. While the present disclosure(s) will be described in conjunction with exemplary embodiments of the present disclosure, it will be understood that the present description is not intended to limit the present disclosure(s) to those exemplary embodiments of the present disclosure. On the other hand, the present disclosure(s) is/are intended to cover not only the exemplary embodiments of the present disclosure, but also various alternatives, modifications, equivalents and other embodiments, which may be included within the spirit and scope of the present disclosure as defined by the appended claims.

Hereinafter, various exemplary embodiments of the present disclosure will be described in detail with reference to the exemplary drawings. In adding the reference numerals to the components of each drawing, it should be noted that the identical component is designated by the identical numerals even when they are displayed on other drawings. Furthermore, a detailed description of well-known features or functions will be ruled out in order not to unnecessarily obscure the gist of the present disclosure.

In describing the components of the exemplary embodiment of the present disclosure, terms such as first, second, "A", "B", (a), (b), and the like may be used. These terms are only used to distinguish one element from another element, but do not limit the corresponding elements irrespective of the order or priority of the corresponding elements.

Furthermore, unless otherwise defined, all terms including technical and scientific terms used herein have the same meaning as being generally understood by those skilled in the art to which the present disclosure pertains. Such terms as those defined in a generally used dictionary are to be interpreted as having meanings equal to the contextual meanings in the relevant field of art, and are not to be interpreted as having ideal or excessively formal meanings unless clearly defined as having such in the present application.

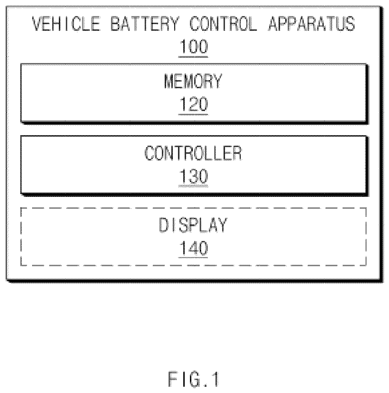

Hereinafter, various exemplary embodiments of the present disclosure will be described in detail with reference to FIGS. 1 to 10.

FIG. 1 is a block diagram illustrating components of a vehicle battery control apparatus according to an exemplary embodiment of the present disclosure.

According to an exemplary embodiment of the present disclosure, a vehicle battery control apparatus 100 may include at least one of a memory 120, a controller 130, or a display 140, or any combination thereof. The components of the vehicle battery control apparatus 100, which are shown in FIG. 1, are illustrative, and embodiments of the present disclosure are not limited thereto. For example, the vehicle battery control apparatus 100 may further include components (e.g., at least one of an interface, a communication device, a sensor device, or a driving device, or any combination thereof) which are not shown in FIG. 1.

According to an exemplary embodiment of the present disclosure, the memory 120 may store a command or data. For example, the memory 120 may store one or more instructions, when executed by the controller 130, causing the vehicle battery control apparatus 100 to perform various operations.

For example, the memory 120 and the controller 130 may be implemented as one chipset. The controller 130 may include at least one of a communication processor or a modem.

According to an exemplary embodiment of the present disclosure, the controller 130 may be operatively connected to the memory 120 and/or the display 140. For example, the controller 130 may be configured for controlling operations of the memory 120 and/or the display 140.

In an exemplary embodiment of the present disclosure, the controller 130 may obtain (or identify) at least one of driving durability data according to a driving state of a host vehicle or calendar aging data according to a parking state of the host vehicle, or any combination thereof.

In an exemplary embodiment of the present disclosure, the controller 130 may establish a hypothesis about a degradation rate of a battery, based on Equation 1 below about the degradation rate.

[Equation 1]

$$Q = min\,(Qsites,\ QLiS,\ QLiP)$$

For example, the degradation rate Q of the battery may be determined based on a minimum value of the parameter $Q_{sites}$ about lithium storage site loss, the parameter $Q_{LiS}$ about generating a solid electrolyte interphase (SEI) layer, and/or the parameter $Q_{LiP}$ about lithium plating.

In an exemplary embodiment of the present disclosure, the controller 130 may obtain (or identify) a state of health (SOH), which is information related to the life (or a performance state) of the battery, based on Equation 2 below using a prediction model (e.g., $SOH_{real}$) about the life of the battery.

[Equation 2]

$$SOH_{real} = 1 - A \times Wh^z - B \times time^z$$

For example, the controller 130 may obtain (or identify) the state of health (SOH). The controller 130 may obtain (or identify) a real-time SOH of the battery based on the parameter $A*Wh^z$ about driving durability and the parameter $B*time^z$ about calendar aging. For example, z may be 0.5, but this is illustrative. Embodiments of the present disclosure are not limited thereto.

Here, the "calendar aging" is a degradation phenomenon of the battery that occurs when the battery is left unused for a period of time.

Here, the "driving durability" is a time period between a time point when the host vehicle is powered on and starts to drive and a time point when the host vehicle is powered off.

In the present disclosure, the term "abandoned" is defined as "in a state of a host vehicle in which the host vehicle is stopped, parked or powered off", the term "abandonment" is defined as "a state of a host vehicle in which the host vehicle is stopped, parked or powered off, and the term "abandonment time" is defined as a time for a host vehicle to be in a state in which the host vehicle is stopped, parked or powered off.

In an exemplary embodiment of the present disclosure, the controller 130 may identify A and B based on Equation 3 below.

[Equation 3]

$$A = f(\theta_I, \theta_T, \theta_{fc})$$

$$B = f(\theta_{CSOC}, \theta_{CT})$$

For example, the controller 130 may obtain (or identify) A and B like Equation 2 described above, using the degradation acceleration rate $\theta_I$ caused by the load, the degradation acceleration rate $\theta_T$ caused by the driving temperature, the degradation acceleration rate $\theta_{CSOC}$ caused by the abandonment state of charge (SoC), the degradation acceleration rate $\theta_{CT}$ caused by the abandonment temperature, and/or the degradation acceleration rate $\theta_{fc}$ caused by the quick charge ratio.
Here, the abandonment state of charge (SoC) is the SOC of the battery while the host vehicle is abandoned, and the abandonment temperature is the temperature of the battery while the host vehicle is abandoned.
In an exemplary embodiment of the present disclosure, the controller 130 may obtain (or identify) the degeneration acceleration rate based on Equation 4 below.

[Equation 4]

$$\theta_I = C_{ia} + C_{ib} * I + C_{ic} * I^2$$

$$\theta_T = \exp\left[C_{ad} \times \left(\frac{1}{Temp_D} - \frac{1}{Temp_{ref}}\right)\right]$$

$$\theta_{CSOC} = C_{soca} + C_{socb} * SOC + C_{socd} * SOC^2$$

$$\theta_{CT} = \exp\left[C_{as} \times \left(\frac{1}{Temp_s} - \frac{1}{Temp_{ref}}\right)\right]$$

$$\theta_{fc} = \frac{1}{C_{fc\_1} \times fc + C_{fc\_2}}$$

For example, some of the above-mentioned parameters of Equation 4 above may be constant values predetermined by an experiment. For example, $Temp_D$ may be a temperature of the battery, which is identified while driving. For example, SOC may be an SOC value of the battery at a time point when the vehicle is abandoned. For example, $Temp_s$ may be a temperature of the battery, which is identified during abandonment. For example, fc may be a value about a ratio between normal charge and quick charge.
For example, when the host vehicle starts to drive, the controller 130 may obtain (or identify) degradation data of the battery, based on at least one of calendar aging data according to a parking state, which is stored in the memory 120 before the host vehicle starts to drive or an existing calendar aging model, or any combination thereof.
The calendar aging data may include at least one of, for example, an abandonment time (e.g., a stop/parking time or a time when the host vehicle is powered off) until the host vehicle starts to drive, a state of charge (SOC) value of the battery at a time point when the host vehicle is abandoned (e.g., a time point when the host vehicle is parked or a time point when the host vehicle is powered off), or a battery temperature at each of the time point when the host vehicle is abandoned and the time point when the host vehicle starts to drive, or any combination thereof.
The existing calendar aging model may be, for example, a model configured to output information related to a state (e.g., a degradation state) of the battery using existing calendar aging data identified in response to a previous abandonment time period by the controller 130, in the previous abandonment time period of the abandonment time before the host vehicle starts to drive.
The degradation data may include, for example, information related to a degradation degree of the battery at a time point when the host vehicle starts to drive (or a time point when the abandonment is ended).

As an exemplary embodiment of the present disclosure, when the host vehicle starts to drive, the controller 130 may accumulate and store driving durability data according to a driving state obtained (or identified) while the host vehicle is driving in the memory 120.

As an exemplary embodiment of the present disclosure, upon concluding that the abandonment time before the host vehicle starts to drive is greater than a predetermined time (e.g., 60 minutes), the controller 130 may store a first calendar aging model configured to obtain (or identify) degradation data of the battery based on at least one of an existing calendar aging model identified in an abandonment time period before the host vehicle starts to drive or calendar aging data, or any combination thereof and output information related to the state (e.g., the degradation state) of the battery using the calendar aging data, the degradation data, and the existing calendar aging model in the memory 120.

The first calendar aging model may be an calendar aging model corresponding to an abandonment time period immediately before the host vehicle starts to drive.

As an exemplary embodiment of the present disclosure, upon concluding that the abandonment time is less than or equal to the predetermined time, the controller 130 may be configured to determine (or identify) and store the existing calendar aging model as the first calendar aging model in the memory 120. In other words, when the abandonment time is less than or equal to the predetermined time, the controller 130 may be configured to determine (or identify) an existing calendar aging model corresponding to a past abandonment time period as calendar aging model corresponding to a current abandonment time period and may store it in the memory 120.

For example, the controller 130 may identify information related to a state of health (SOH) of the battery in an nth abandonment time period based on Equation 5 below using the first calendar aging model corresponding to the nth abandonment time period.

[Equation 5]

$$SOH_{real}^n = 1 - C_s \times \left( \left( \frac{1 - SOH_{real}^{n-1}}{C_s} \right)^{\frac{1}{zS}} + Time\_s \right)^{zS}$$

For example, the value determined based on the first calendar aging model may be the SOH of the battery, which corresponds to the nth abandonment time period. For example, Time_s may be the abandonment time in the nth abandonment time period. For example, zS may be 0.5, but this is illustrative. Embodiments of the present disclosure are not limited thereto.

For example, the constant Cs may be identified based on Equation 6 below.

[Equation 6]

$$C_{soc} = C_{soca} + C_{socb} \times SoC_s + C_{socd} \times SoC_s^2$$

$$C_s = C_{soc} \times \exp[C_{as} \times (\frac{1}{Temp\_s})]$$

For example, $C_{soca}$, $C_{socb}$, and $C_{socd}$ may be predefined parameters (e.g., parameters identified as optimization values in a development stage). For example, SoCs may be an SOC value of the battery at a time point when the host vehicle is abandoned. For example, Temp_s may be an average value between a battery temperature at a time point when the host vehicle is abandoned and a battery temperature at a time point when the host vehicle starts to drive after the abandonment time period immediately before the host vehicle starts to drive is ended.

For example, when the host vehicle ends driving and is powered off, the controller 130 may identify degradation data of the battery, based on at least one of driving durability data according to a driving state, which is stored in the memory 120 before the host vehicle is powered off, or an existing driving durability model, or any combination thereof.

The driving durability data may include at least one of energy used until the host vehicle is powered off (e.g., until the host vehicle is powered off from a time point when the host vehicle is powered on and starts to drive), a current used while the host vehicle is driving, or an average battery temperature while the host vehicle is driving, or any combination thereof.

The existing driving durability model may be, for example, a model configured using existing driving durability data identified in response to a previous driving period by the controller 130, in the previous driving period of the driving time before the host vehicle is powered off.

The degradation data may include, for example, information related to a degradation degree of the battery at a time point when the host vehicle ends driving and is powered off (or a time point when the driving is ended).

As an exemplary embodiment of the present disclosure, when the host vehicle ends driving and is powered off, the controller 130 may accumulate and store calendar aging data according to a parking state during abandonment in the memory 120.

As an exemplary embodiment of the present disclosure, upon concluding that energy used while driving before the host vehicle is powered off is greater than a specified amount (e.g., 0.5 Wh), the controller 130 may identify degradation data of the battery based on at least one of the existing driving durability model identified in the driving period before the host vehicle is powered off or the driving durability data, or any combination thereof. The controller 130 may store the first driving durability model determined (or identified) using the driving durability data, the degradation data, and the existing driving durability model in the memory 120.

The first driving durability model may be a driving durability model corresponding to a driving period immediately before the host vehicle is powered off.

As an exemplary embodiment of the present disclosure, upon concluding that the abandonment time is less than or equal to the predetermined time, the controller 130 may be configured to determine (or identify) and store the existing calendar aging model as the first calendar aging model in the memory 120. In other words, when the abandonment time is less than or equal to the predetermined time, the controller 130 may be configured to determine (or identify) an existing calendar aging model corresponding to a past abandonment time period as calendar aging model corresponding to a current abandonment time period and may store it in the memory 120.

For example, the controller 130 may identify an SOH of the battery, which corresponds to the nth driving period, based on Equation 7 below using the first driving durability model corresponding to the nth driving period.

[Equation 7]

$$SOH_{d\_real}^{n} = 1 - C_D \times \left( \left( \frac{1 - SOH_{d\_real}^{n-1}}{C_D} \right)^{\frac{1}{zD}} + kWh\_d \right)^{zD}$$

For example, the value determined based on the first driving durability model may be the SOH of the battery, which corresponds to the nth driving period. For example, kWh_d may be energy used in the nth driving period. For example, zD may be 0.5, but this is illustrative. Embodiments of the present disclosure are not limited thereto.

For example, the constant $C_D$ may be identified based on Equation 8 below.

[Equation 8]

$$C_i = C_{ia} + C_{ib} \times I_{rms\_d} + C_{id} \times I_{rms\_d}^{2}$$

$$C_D = C_i \times \exp[C_{ad} \times (\frac{1}{Temp\_avg})]$$

For example, $C_{ia}$, $C_{ib}$, and $C_{id}$ may be predefined parameters (e.g., parameters identified as optimization values in the development stage). For example, $I_{rms\_d}$ may be an RMS value of the current used while driving. For example, Temp_avg may be an average battery temperature while driving. As an exemplary embodiment of the present disclosure, $I_{rms\_d}$ and Temp_avg may be identified based on Equation 9 below.

[Equation 9]

$$I_{rms\_d} = \sqrt{\frac{1}{n} \sum_{k=1}^{n} I_k^2}$$

$$Temp\_avg = \frac{1}{n} \sum_{k=1}^{n} Temp_k$$

For example, when the host vehicle ends driving and is powered off, the controller 130 may identify a reference model including a reference calendar aging model and/or a reference driving durability model. The controller 130 may be configured to determine (or identify), for example, the reference model based on reference durability data about at least one of a current, a temperature of the battery, or an SOC value, or any combination thereof.

As an exemplary embodiment of the present disclosure, the controller 130 may be configured to determine (or identify) the reference calendar aging model based on an abandonment time when the host vehicle is actually abandoned, together with the reference durability data about at least one of the temperature of the battery or the SOC value, or any combination thereof. The controller 130 may newly determine (or identify) an existing calendar aging model, only when the abandonment time is greater than the predetermined time (e.g., 60 minutes) and may be configured to determine (or identify) and store a reference calendar aging model identified in an existing abandonment time period (or a previous abandonment time period) as a reference calendar aging model corresponding to a recent abandonment time period, when the abandonment time is less than or equal to the predetermined time, in the memory 120.

For example, the controller 130 may identify a reference SOH of the battery based on the reference calendar aging model corresponding to the nth abandonment time period according to Equation 10 below.

[Equation 10]

$$SOH_{s\_ref}^n = 1 - C_{s\_ref} \times \left( \left( \frac{1 - SOH_{s\_ref}^{n-1}}{C_s} \right)^{\frac{1}{zS}} + time\_s \right)^{zS}$$

For example, the value determined based on the reference calendar aging model may be the reference SOH corresponding to the nth abandonment time period. For example, Time_s may be the actual abandonment time in the nth abandonment time period. For example, zS may be 0.5, but this is illustrative. Embodiments of the present disclosure are not limited thereto.

For example, the constant $C_{s\_ref}$ may be identified based on Equation 11 below.

[Equation 11]

$$C_{soc}\_ref = C_{soci} + C_{socs} \times SoC\_ref + C_{socd} \times SoC\_ref^2$$

$$C_{s\_ref} = C_{soc}\_ref \times exp[C_{as} \times (\frac{1}{Temp_s\_ref} - \frac{1}{273.15})]$$

For example, SoC_ref and $Temp_{s\_ref}$ may be a reference SOC value and a reference abandonment temperature, which are preset by an experiment, respectively.

As an exemplary embodiment of the present disclosure, the controller 130 may be configured to determine (or identify) a reference driving durability model based on a magnitude of energy actually used in the driving period by the host vehicle, together with the reference durability data about at least one of the current or the temperature of the battery, or any combination thereof. The controller 130 may newly determine (or identify) a reference driving durability model, only when the amount of energy is greater than a specified magnitude (e.g., 0.5 Wh) and may be configured to determine (or identify) and store a reference driving durability model identified in an existing driving period (or a previous driving period) as a reference driving durability model corresponding to a recent driving period, when the amount of energy is less than or equal to the specified magnitude, in the memory 120.

For example, the controller 130 may identify a reference SOH of the battery based on the reference driving durability model corresponding to the nth driving period according to Equation 12 below.

[Equation 12]

$$SOH_{d\_ref}^n = 1 - C_D \times \left( \left( \frac{1 - SOH_{d\_ref}^{n-1}}{C_D} \right)^{\frac{1}{zD}} + kWh\_d \right)^{zD}$$

For example, the value determined based on the reference driving durability model may be the reference SOH corresponding to the nth driving period. For example, kWh_d may be energy actually used in the nth driving period. For example, zD may be 0.5, but this is illustrative. Embodiments of the present disclosure are not limited thereto.

For example, the constant $C_D$ may be identified based on Equation 13 below.

[Equation 13]

$$\Box_\Box = \Box_{\Box\Box} + \Box_{\Box\Box} \times \Box_{\Box\Box\Box}\_ref + \Box_{\Box\Box} \times \Box_{\Box\Box\Box}\_{\Box\Box\Box}^2$$

$$\Box_\Box = \Box_\Box \times \Box\Box\Box[\Box_{\Box\Box} \times (\frac{1}{\Box\Box\Box\Box_{\Box\Box\Box}\_{\Box\Box\Box}})]$$

For example, $C_{ia}$, $C_{ib}$, and $C_{id}$ may be predefined parameters (e.g., parameters identified as optimization values in a development stage). For example, $I_{rms\_ref}$ and $Temp_{avg\_ref}$ may be a reference current and a reference driving average temperature, which are preset by an experiment, respectively.

For example, the controller 130 may compare the reference data identified by inputting at least one of at least a portion of the driving durability data or at least a portion of the calendar aging data, or any combination thereof to the reference model with the degradation data to identify a degradation state of the battery.

As an exemplary embodiment of the present disclosure, the controller 130 may identify a score about a degradation degree of the battery, based on a difference between the reference data and the degradation data. The controller 130 may identify, for example, various user interfaces about the degradation degree of the battery based on the magnitude of the score. The controller 130 may identify, for example, a score based on Equation 14 below.

[Equation 14]

$$score = \{SOH^n_{ref} - SOH^n_{real}\}*100$$

As an exemplary embodiment of the present disclosure, the controller 130 may display at least one of a predetermined battery state notification corresponding to the magnitude of the score among a plurality of battery state notifications or a battery operation guide identified based on a battery usage history, or any combination thereof, using the display 140.

The battery state notification may include, for example, information related to a current state of the battery and a state of the battery expected at a predetermined time point in the future and/or information related to a battery management state.

As an exemplary embodiment of the present disclosure, the battery state notification may include a sentence about battery state information and information related to a management scheme (e.g., "The current battery management state is good. Manage it like you do now.", "The current battery management state is normal. Please refer to the management guide for battery life.", and/or "The current battery management state is caution. Please refer to the management guide for battery life."). The controller 130 may select, for example, a sentence corresponding to the state of the battery among at least one sentence and may provide the user with the selected sentence.

The battery operation guide may include at least one of a ratio between normal charge and quick charge, a ratio between normal driving and driving at rapid acceleration and deceleration, an amount of average charging of the battery while parked, or an average temperature of the battery while driving, or any combination thereof.

The battery operation guide may include a sentence about a battery management state (e.g., "Battery management is working well.").

As an exemplary embodiment of the present disclosure, the battery operation guide may include a sentence about recommending a battery charging type (e.g., "Slow charge helps maintain battery performance rather than quick charge. We recommend using it mainly for slow charge.").

As an exemplary embodiment of the present disclosure, the battery operation guide may include a sentence about recommending a driving type of the host vehicle (e.g., "Rapid acceleration/deceleration does not help manage battery life. We recommend smoother driving than now.").

As an exemplary embodiment of the present disclosure, the battery operation guide may include a sentence about recommending a battery capacity in a state in which the host vehicle is not driving (e.g., "Low battery capacity does not help maintain battery performance when not driving for a long time. We recommend charging around 50-80%." or "High battery capacity does not help maintain battery performance when not driving for a long time. We recommend charging around 50-80%.").

As an exemplary embodiment of the present disclosure, the battery operation guide may include a sentence about a charging type or a driving scheme for suitably maintaining a battery temperature (e.g., "Reducing the use of quick charge and high-speed driving to maintain an appropriate battery temperature will help maintain battery life and performance.")

As an exemplary embodiment of the present disclosure, the battery operation guide may include a sentence about recommending battery management (e.g., "To maintain battery life and performance, we recommend using battery conditioning to maintain appropriate battery temperature.").

For example, when identifying that the state of the battery is good based on the score, the controller 130 may immediately change the type of the battery state notification.

For example, the controller 130 may maintain and display the type of the battery state notification which is previously displayed a specified number of times (e.g., 5 times), when identifying that the state of the battery deteriorates based on the score. After identifying that the state of the battery deteriorates continuously during a period greater than the specified number of times, the controller 130 may change and display the type of the battery state notification.

The components of the vehicle battery control apparatus 100 of FIG. 1 are illustrative, and the vehicle battery control apparatus 100 may further include components which are not shown. For example, the vehicle battery control apparatus 100 may further include a sensor device.

According to an exemplary embodiment of the present disclosure, the sensor device may obtain (or sense) various pieces of information related to components included in the vehicle and/or a driving situation of the vehicle.

For example, the sensor device may include a thermal sensor configured for identifying a temperature of the battery. The sensor device may identify (or monitor) a temperature of the battery in real time, under control of the controller 130.

For example, the sensor device may include at least one sensor including at least one of a camera, radio detection and ranging (RADAR), or light detection and ranging (LiDAR), or any combination thereof. The sensor device may identify various pieces of information (e.g., at least one of a driving speed, driving acceleration, a driving direction, whether the host vehicle is stopped (or an abandonment time), or a stop time, or any combination thereof) about the driving of the host vehicle in real time, under control of the controller 130.

In the above-mentioned embodiment, it may be understood that the operation performed by the sensor device is performed by control of the controller 130.

According to various exemplary embodiments of the present disclosure, the vehicle battery control apparatus 100 may monitor a battery state of a vehicle which is a target (e.g., a vehicle including the vehicle battery control apparatus 100) in real time and may measure a battery degradation state based on the battery state. By such a technical feature, reliability may be greater than that in a method for measuring and predicting a state (e.g., a state of health (SOH)) of the battery based on a cloud technology in an external device (e.g., server) stage, and the state of the battery may be rapidly measured.

According to various exemplary embodiments of the present disclosure, the vehicle battery control apparatus 100 may be configured to determine a degradation state of the battery with regard to both of an abandonment history and a driving history of the host vehicle, based on at least one model (e.g., an calendar aging model and/or a driving durability model) provided in the host vehicle as the target. As a result, the vehicle battery control apparatus 100 may rapidly predict and determine a degradation state of the battery with high accuracy.

According to various exemplary embodiments of the present disclosure, as the abandonment time period and the driving period of the host vehicle elapse, the vehicle battery control apparatus 100 may be configured to determine whether to use a new calendar aging model and/or a new driving durability model based on various pieces of information (e.g., information related to an abandonment and/or driving time and operation of the host vehicle in a corresponding period), thus accurately predicting a battery management guide, a management time point, and the like and providing the user with them.

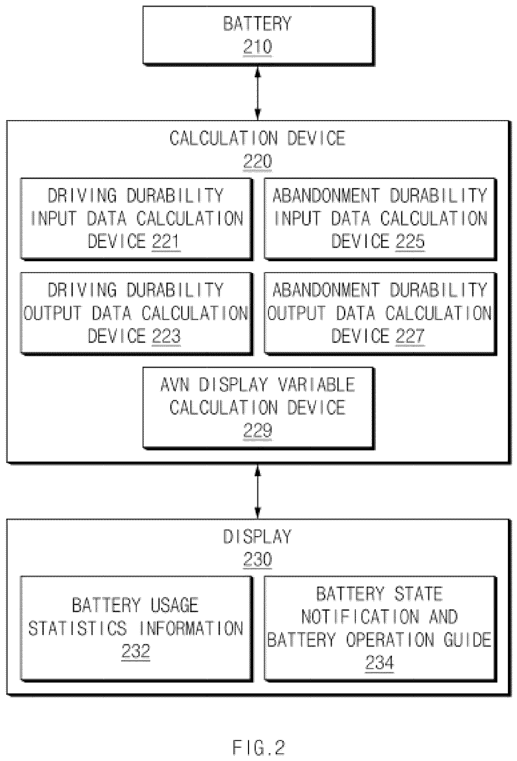

FIG. 2 is a block diagram illustrating components of a vehicle battery control apparatus according to an exemplary embodiment of the present disclosure.

According to an exemplary embodiment of the present disclosure, a vehicle battery control apparatus (e.g., a vehicle battery control apparatus 100 of FIG. 1) may include a calculation device 220 and/or a display 230. The vehicle battery control apparatus may be operatively connected to the battery 210.

For example, the calculation device 220 may include at least one of a driving durability input data calculation device 221, a driving durability output data calculation device 223, an calendar aging input data calculation device 225, an calendar aging output data calculation device 227, or an audio, video, navigation (AVN) display variable calculation device 229, or any combination thereof.

As an exemplary embodiment of the present disclosure, the driving durability input data calculation device 221 may be configured to determine (or identify) an input variable about at least one of a current while driving, a driving temperature, an amount of driving energy, or a charge rate, or any combination thereof.

As an exemplary embodiment of the present disclosure, the driving durability output data calculation device 223 may be configured to determine an SOH while driving using driving durability input data based on a driving durability model.

As an exemplary embodiment of the present disclosure, the calendar aging input data calculation device 225 may be configured to determine (or identify) an input variable about at least one of a parking time (or an abandonment time), a parking SoC (or an SoC at a time point when the host vehicle is abandoned), or a parking temperature (or a temperature of the battery 210 at the point when the host vehicle is abandoned), or any combination thereof.

As an exemplary embodiment of the present disclosure, the calendar aging output data calculation device 227 may be configured to determine (or identify) an SOH during abandonment using calendar aging input data based on an calendar aging model.

As an exemplary embodiment of the present disclosure, the Audio, Video and Navigation (AVN) display variable calculation device 229 may accumulate and determine at least one piece of information related to the battery 210, which will be provided to the user through a display (e.g., a display 140 of FIG. 1). For example, the at least one piece of information related to the battery 210, which will be provided to the user, may include at least one of a ratio between normal charge and quick charge, a ratio between normal driving and driving at rapid acceleration and deceleration, an amount of average charging of the battery 210 while parked, an average temperature of the battery 210 while driving, or an SoC at a time point when the host vehicle is abandoned, or any combination thereof.

For example, the display 230 may display battery usage statistics information 232 and/or a battery state notification and battery operation guide 234.

As an exemplary embodiment of the present disclosure, the battery usage statistics information 232 may include information related to a usage history of the battery 210. For example, the battery usage statistics information 232 may include information related to at least one of a charging type (e.g., a ratio between normal (or slow) charge and quick charge) of the battery 210, a type of a road on which the battery 210 is used (e.g., a ratio between city driving and highway driving), a driving speed type of the host vehicle driving using the battery 210 (e.g., a ratio between driving at rapid acceleration and deceleration using rapid deceleration and rapid acceleration and normal driving), a remaining battery capacity while parked, or a battery temperature while driving, or any combination thereof.

As an exemplary embodiment of the present disclosure, the battery state notification and battery operation guide 234 may include battery state information identified based on a score determined based on the result of comparing reference data and degradation data.

The battery state notification may include, for example, stage 1 (e.g., "good", the current battery management state is good. Manage it as you do now.), stage 2 (e.g., "normal", the current battery management state is normal. Please refer to the management guide for the life of the battery 210), and stage 3 (e.g., "caution", the current battery management state is caution. Please refer to the management guide for the life of the battery 210).

The battery operation guide may include information include at least one of a ratio between normal charge and quick charge, a ratio between normal driving and driving at rapid acceleration and deceleration, an amount of average charging of the battery 210 while parked, or an average temperature of the battery 210 while driving, or any combination thereof.

The battery operation guide may include at least one of a first type (e.g., "Battery management is working well."), a second type (e.g., "Slow charge helps maintain battery performance rather than quick charge. We recommend using it mainly for slow charge."), a third type (e.g., "Rapid acceleration or deceleration does not help manage battery life. We recommend smoother driving than now."), a fourth type (e.g., "Low battery capacity does not help maintain battery performance when not driving for a long time. We recommend charging around 50-80%."), a fifth type (e.g., "High battery capacity does not help maintain battery performance when not driving for a long time. We recommend charging around 50-80%."), a sixth type (e.g., "Reducing the use of fast charge and high-speed driving to maintain an appropriate battery temperature will help maintain battery life and performance."), or a seventh type (e.g., "We recommend using battery conditioning to maintain proper battery temperature to maintain battery life and performance."), or any combination thereof. The vehicle battery control apparatus may select at least one of, for example, various types battery operation guides and may display it to the user on the display, based on the battery usage history.

The components of the vehicle battery control apparatus, which are shown in FIG. 2, are illustrative, and embodiments of the present disclosure are not limited thereto. For example, the calculation device 220 shown in FIG. 2 may be implemented as a portion of the controller (e.g., a controller 130 of FIG. 1) described above or as one chip.

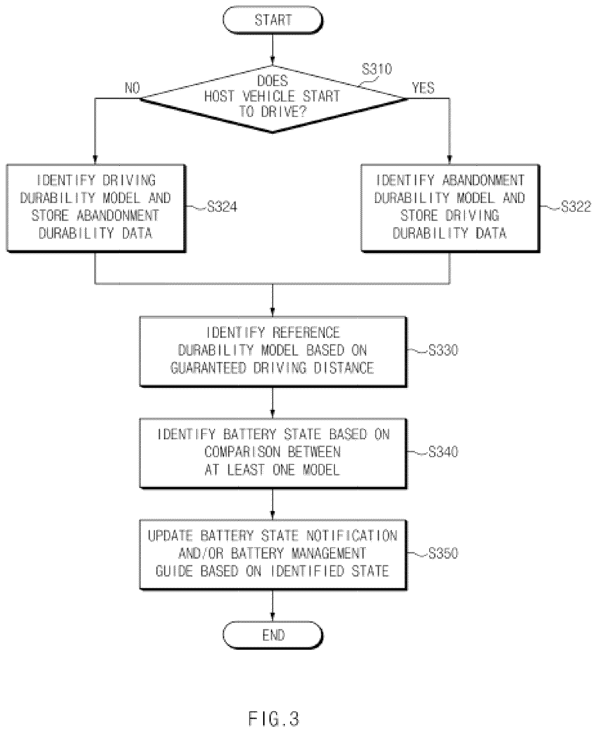

FIG. 3 is a flowchart of an operation of a vehicle battery control apparatus according to an exemplary embodiment of the present disclosure.

According to an exemplary embodiment of the present disclosure, a vehicle battery control apparatus (e.g., a vehicle battery control apparatus 100 of FIG. 1) may perform operations included in FIG. 3. For example, at least some of components (e.g., a memory 120, a controller 130, and/or a display 140 of FIG. 1) included in the vehicle battery control apparatus may be configured to perform the operations of FIG. 3.

Operations in S310 to S350 in an exemplary embodiment below may be sequentially performed, but are not necessarily sequentially performed. For example, an order of the respective operations may be changed, and at least two operations may be performed in parallel. Furthermore, contents, which correspond to or are duplicated with the contents described above in conjunction with FIG. 3, may be briefly described or omitted.

According to an exemplary embodiment of the present disclosure, in S310, the vehicle battery control apparatus may identify whether a host vehicle starts to drive.

For example, the vehicle battery control apparatus may identify whether the host vehicle is powered on and starts to drive.

For example, when it is identified that the host vehicle starts to drive (e.g., S310 - YES), the vehicle battery control apparatus may perform S322.

For example, when it is identified that the host vehicle does not start to travel (e.g., S310 - NO), the vehicle battery control apparatus may perform S324. For example, that the host vehicle does not start to travel may include that the host vehicle ends driving and is powered off.

According to an exemplary embodiment of the present disclosure, in S322, the vehicle battery control apparatus may identify an calendar aging model and may store driving durability data.

For example, the vehicle battery control apparatus may be configured to determine (or identify) the calendar aging model using at least some of calendar aging data stored in a memory in an abandonment time period immediately before the host vehicle starts to drive.

For example, the vehicle battery control apparatus may store driving durability data according to a driving state which is being performed based on the start of the driving in S 310 in the memory in real time.

According to an exemplary embodiment of the present disclosure, in S324, the vehicle battery control apparatus may identify a driving durability model and may store calendar aging data.

For example, the vehicle battery control apparatus may be configured to determine (or identify) the driving durability model using at least some of driving durability data stored in the memory in a driving period immediately before the host vehicle starts to be abandoned (or before the host vehicle ends driving and powered off).

For example, the vehicle battery control apparatus may store calendar aging data according to a parking state (or an abandonment state) which is being performed based on the start of the abandonment in S310 in the memory in real time.

According to an exemplary embodiment of the present disclosure, in S330, the vehicle battery control apparatus may identify a reference durability model based on a guaranteed driving distance.

For example, the vehicle battery control apparatus may be configured to determine (or identify) a reference durability model (or a reference model) provided to predict the life of the battery based on a specified guaranteed driving distance (e.g., 160,000 km). The reference durability model may include, for example, a reference driving durability model and/or a reference calendar aging model. The vehicle battery control apparatus may be configured to predict and determine reference information (e.g., a reference life state) of the battery based on the reference durability model according to Equation(s) 10 and/or 12 described above.

According to an exemplary embodiment of the present disclosure, in S340, the vehicle battery control apparatus may be configured to determine (or identify) a battery state based on a comparison between at least one model.

For example, the vehicle battery control apparatus may be configured to determine (or identify) a battery state (e.g., a degradation state of the battery) including a battery degradation degree based on the result of the comparison between pieces of data determined based on at least one of the driving durability model, the calendar aging model, or the reference model, or any combination thereof.

For example, the vehicle battery control apparatus may identify a battery state based on a difference between reference data determined by inputting operation information (e.g., an abandonment time and/or used energy) of the vehicle, which is identified in real time, to at least one of the driving durability model, the calendar aging model, or the reference model, or any combination thereof and/or degradation data.

According to an exemplary embodiment of the present disclosure, in S350, the vehicle battery control apparatus may update a battery state notification and/or a battery management guide based on the identified state.

For example, the vehicle battery control apparatus may update (or display) the battery state notification and/or the battery management guide based on the identified state.

As an exemplary embodiment of the present disclosure, when the vehicle starts to drive, the vehicle battery control apparatus may identify a battery state of the vehicle based on a magnitude of a difference between degradation data determined based on an calendar aging model and calendar aging data stored in the memory in an immediately previously abandonment time period and reference data determined based on a reference calendar aging model stored in the memory in the immediately previously abandonment time period and the above-mentioned calendar aging data and may update the battery state notification and/or the battery management guide of the vehicle.

As an exemplary embodiment of the present disclosure, when the vehicle starts to be abandoned (or when the vehicle ends driving and is powered off), the vehicle battery control apparatus may identify a battery state of the vehicle based on a magnitude of a difference between degradation data determined based on a driving durability model and driving durability data stored in the memory in an immediately previously abandonment time period and reference data determined based on a reference driving durability model stored in the memory in the immediately previously abandonment time period and the above-mentioned driving durability data and may update the battery state notification and/or the battery management guide of the vehicle.

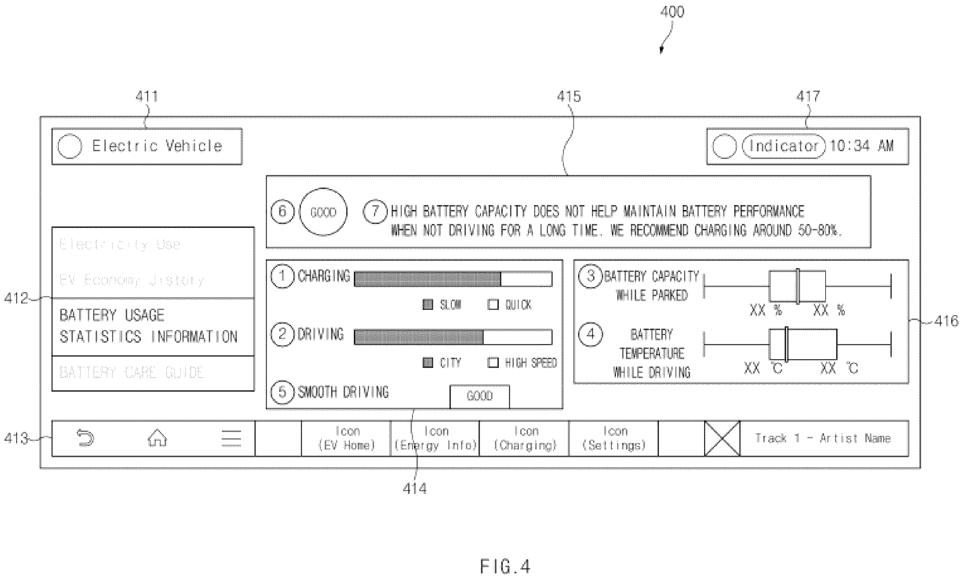

FIG. 4 is a drawing illustrating a user interface provided by a vehicle battery control apparatus according to an exemplary embodiment of the present disclosure.

According to an exemplary embodiment of the present disclosure, a vehicle battery control apparatus (e.g., a vehicle battery control apparatus 100 of FIG. 1) may display various pieces of information related to a battery state of a vehicle to a user using a display 400 (e.g., a display 140 of FIG. 1).

For example, the vehicle battery control apparatus may display a first user interface 411 including identification information of the vehicle to the user.

For example, the vehicle battery control apparatus may display a second user interface 412 including a plurality of screen switching taps about a change in display screen type to the user. As an exemplary embodiment of the present disclosure, the screen shown in FIG. 4 may be a display screen on which a "battery usage statistics information" tap selected.

For example, the vehicle battery control apparatus may display a third user interface 413 including a menu tap about at least one of displaying a previous screen, displaying a home screen display, a menu, energy information, charging information, settings, or content information which is being played, or any combination thereof to the user.

For example, the vehicle battery control apparatus may display a fourth user interface 414 including at least one of a ratio of a charging type of the vehicle (e.g., a ratio between slow charge and quick charge), a ratio of a driving type (e.g., a ratio between city driving and highway driving), or a ratio about a driving type (e.g., a ratio between normal driving and driving at rapid acceleration/rapid deceleration), or any combination thereof to the user.

For example, the vehicle battery control apparatus may display a fifth user interface 415 including a battery state notification and/or a battery management guide of the vehicle to the user. As an exemplary embodiment of the present disclosure, the vehicle battery control apparatus may display the battery state notification and the battery management guide determined based on the difference between the reference data and the degradation data and may update at least a portion of the fifth user interface 415 in real time depending on the battery state change identified in real time.

For example, the vehicle battery control apparatus may display a sixth user interface 416 including at least one of a battery capacity while parked (e.g., an average battery SoC at a time point when the vehicle is parked (or when the vehicle ends driving and is powered off)) or a battery temperature while driving (e.g., a real-time average temperature of the battery while driving), or any combination thereof to the user.

For example, the vehicle battery control apparatus may display a seventh user interface 417 including at least one of a search function or time information, or any combination thereof to the user.

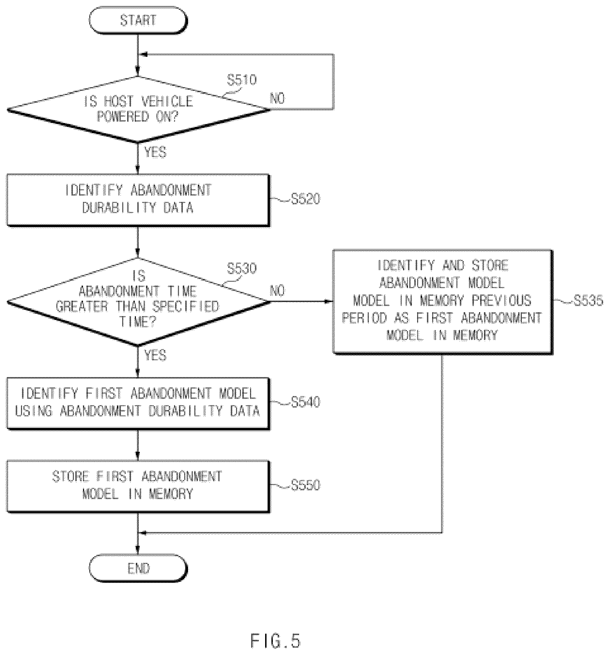

FIG. 5 is a flowchart of a vehicle battery control method according to an exemplary embodiment of the present disclosure.

According to an exemplary embodiment of the present disclosure, a vehicle battery control apparatus (e.g., a vehicle battery control apparatus 100 of FIG. 1) may perform operations included in FIG. 5. For example, at least some of components (e.g., a memory 120, a controller 130, and/or a display 140 of FIG. 1) included in the vehicle battery control apparatus may be configured to perform the operations of FIG. 5.

Operations in S510 to S550 in an exemplary embodiment below may be sequentially performed, but are not necessarily sequentially performed. For example, an order of the respective operations may be changed, and at least two operations may be performed in parallel. Furthermore, contents, which correspond to or are duplicated with the contents described above in conjunction with FIG. 5, may be briefly described or omitted.

According to an exemplary embodiment of the present disclosure, in S510, the vehicle battery control apparatus may identify whether a host vehicle is powered on.

For example, the vehicle battery control apparatus may identify whether the vehicle is powered on and starts to drive.

For example, when it is identified that the host vehicle is powered on (or when it is identified that the host vehicle starts to drive) (e.g., S510 - YES), the vehicle battery control apparatus may perform S520.

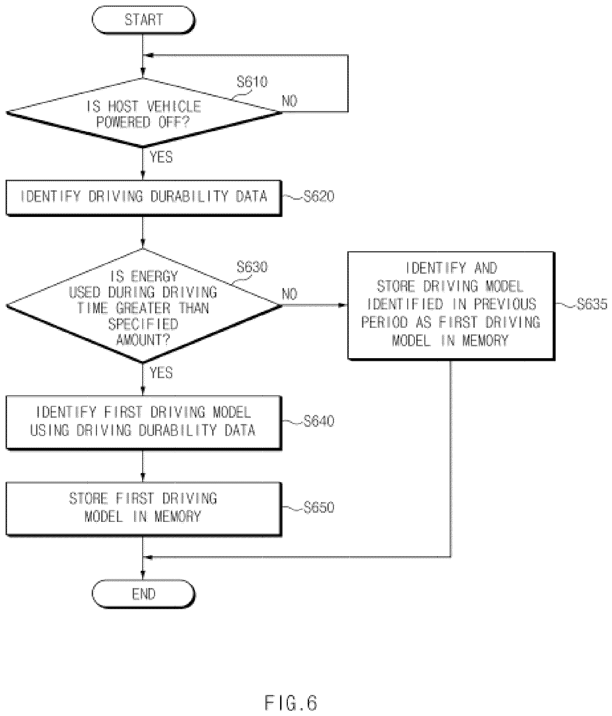

For example, when it is identified that the host vehicle is not powered on (or when the host vehicle is abandoned) (e.g., S510 - NO), the vehicle battery control apparatus may repeatedly perform S510. The present case may be a situation in which the host vehicle continues being abandoned. At the instant time, the vehicle battery control apparatus may perform an operation of storing calendar aging data according to FIG. 6 which will be described below and/or an operation of determining (or identifying) a first driving model (or a first driving durability model) corresponding to an nth period using a driving durability model identified in an abandonment time period (or a parking period) identified in an n-1th period.

According to an exemplary embodiment of the present disclosure, in S520, the vehicle battery control apparatus may identify calendar aging data.

For example, the calendar aging data may include at least one of an abandonment time until the host vehicle starts to drive, a state of charge (SOC) value of the battery at a time point when the host vehicle is abandoned, or a battery temperature at each of the time point when the host vehicle is abandoned and the time point when the host vehicle starts to drive, or any combination thereof.

According to an exemplary embodiment of the present disclosure, in S530, the vehicle battery control apparatus may identify whether the abandonment time is greater than a predetermined time (e.g., 60 minutes).

For example, when the abandonment time is greater than the predetermined time (e.g., S530 - YES), the vehicle battery control apparatus may perform S540.

For example, when the abandonment time is less than or equal to the predetermined time (e.g., S530 - NO), the vehicle battery control apparatus may perform S535.

According to an exemplary embodiment of the present disclosure, in S535, the vehicle battery control apparatus may identify and store an abandonment model identified in a previous period as a first abandonment model in a memory.

In other words, assuming that the driving period according to the driving in S510 is an nth driving period, the vehicle battery control apparatus may be configured to determine (or identify) and store an existing abandonment model identified in a driving period (e.g., an n-1th driving period) immediately before the nth period as the first abandonment model in the memory, when the abandonment time is less than or equal to the predetermined time.

According to an exemplary embodiment of the present disclosure, in S540, the vehicle battery control apparatus may identify the first abandonment model using the calendar aging data.

For example, the vehicle battery control apparatus may identify a battery state of the vehicle using at least one of the existing abandonment model identified in the n-1th abandonment time period or the calendar aging data, or any combination thereof.

For example, the vehicle battery control apparatus may newly determine (or identify) the first abandonment model, which is distinguished from the existing abandonment model and corresponds to the nth abandonment time period, using at least one of the existing abandonment model or the calendar aging data, or any combination thereof.

According to an exemplary embodiment of the present disclosure, in S550, the vehicle battery control apparatus may store the first abandonment model in the memory.

For example, the memory may be a non-volatile memory. Thus, even when the vehicle is powered off and switches to an on-state, the vehicle battery control apparatus may read pieces of data stored before the vehicle is powered off from the memory.

FIG. 6 is a flowchart of a vehicle battery control method according to an exemplary embodiment of the present disclosure.

According to an exemplary embodiment of the present disclosure, a vehicle battery control apparatus (e.g., a vehicle battery control apparatus 100 of FIG. 1) may perform operations included in FIG. 6. For example, at least some of components (e.g., a memory 120, a controller 130, and/or a display 140 of FIG. 1) included in the vehicle battery control apparatus may be configured to perform the operations of FIG. 6.

Operations in S610 to S650 in an exemplary embodiment below may be sequentially performed, but are not necessarily sequentially performed. For example, an order of the respective operations may be changed, and at least two operations may be performed in parallel. Furthermore, contents, which correspond to or are duplicated with the contents described above in conjunction with FIG. 6, may be briefly described or omitted.

According to an exemplary embodiment of the present disclosure, in S610, the vehicle battery control apparatus may identify whether a host vehicle is powered off.

For example, the vehicle battery control apparatus may identify whether the vehicle ends driving and is powered off.

For example, when it is identified that the host vehicle is powered off (or when it is identified that the host vehicle ends driving and is powered off) (e.g., S610 - YES), the vehicle battery control apparatus may perform S620.

For example, when it is identified that the host vehicle is not powered off (or when it is identified that the host vehicle is driving) (e.g., S610 - NO), the vehicle battery control apparatus may repeatedly perform S610. The present case may be a situation in which the host vehicle continues driving. At the instant time, the vehicle battery control apparatus may perform an operation of storing driving durability data according to FIG. 5 described above and/or an operation of determining (or identifying) a first abandonment model (or a first calendar aging model) corresponding to an nth period using an calendar aging model identified in a driving period identified in an n-1th period.

According to an exemplary embodiment of the present disclosure, in S620, the vehicle battery control apparatus may identify driving durability data.

For example, the driving durability data may include at least one of energy used until the host vehicle is powered off, a current used while the host vehicle is driving, or an average battery temperature while driving, or any combination thereof.

According to an exemplary embodiment of the present disclosure, in S630, the vehicle battery control apparatus may identify whether the energy used during the driving time is greater than a specified amount (e.g., 0.5 Wh).

For example, when the energy used during the driving time is greater than the specified amount (e.g., S630 - YES), the vehicle battery control apparatus may perform S640.

For example, when the energy used during the driving time is less than or equal to the specified amount (e.g.,

S630 - NO), the vehicle battery control apparatus may perform S635.

According to an exemplary embodiment of the present disclosure, in S635, the vehicle battery control apparatus may identify and store a driving model identified in a previous period as a first driving model in a memory.

In other words, assuming that the abandonment time period as the host vehicle is powered off in S610 is an nth abandonment time period, the vehicle battery control apparatus may identify and store an existing driving model identified in an abandonment time period (e.g., the n-1th abandonment time period) immediately before the nth abandonment time period as the first driving model in the memory, when the energy used during the driving time is less than or equal to the specified amount.

According to an exemplary embodiment of the present disclosure, in S640, the vehicle battery control apparatus may identify the first driving model using the driving durability data.

For example, the vehicle battery control apparatus may identify a battery state of the vehicle using at least one of the existing driving model determined (or identified) in the n-1th abandonment time period or the driving durability data, or any combination thereof.

For example, the vehicle battery control apparatus may newly determine (or identify) the first driving model, which is distinguished from the existing driving model and corresponds to the nth driving period, using at least one of the existing driving model or the driving durability data, or any combination thereof.

According to an exemplary embodiment of the present disclosure, in S650, the vehicle battery control apparatus may store the first driving model in the memory.

For example, the memory may be a non-volatile memory. Thus, even when the vehicle is powered off and switches to an on-state, the vehicle battery control apparatus may read pieces of data stored before the vehicle is powered off from the memory.

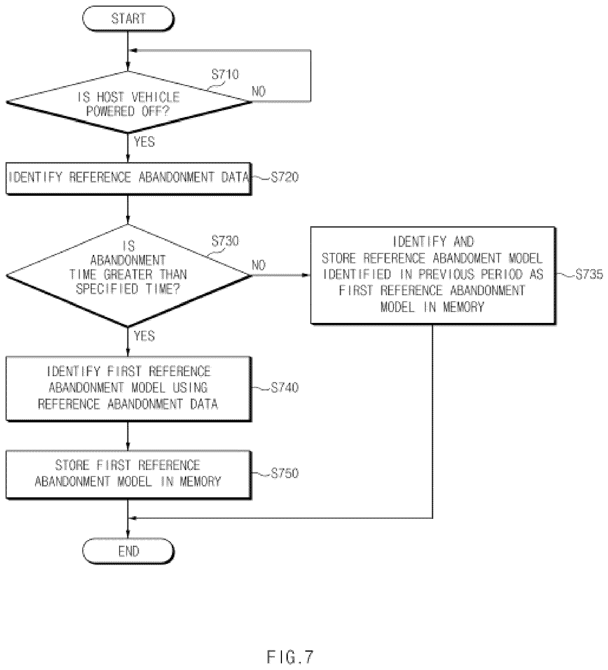

FIG. 7 is a flowchart of a vehicle battery control method according to an exemplary embodiment of the present disclosure.

According to an exemplary embodiment of the present disclosure, a vehicle battery control apparatus (e.g., a vehicle battery control apparatus 100 of FIG. 1) may perform operations included in FIG. 7. For example, at least some of components (e.g., a memory 120, a controller 130, and/or a display 140 of FIG. 1) included in the vehicle battery control apparatus may be configured to perform the operations of FIG. 7.

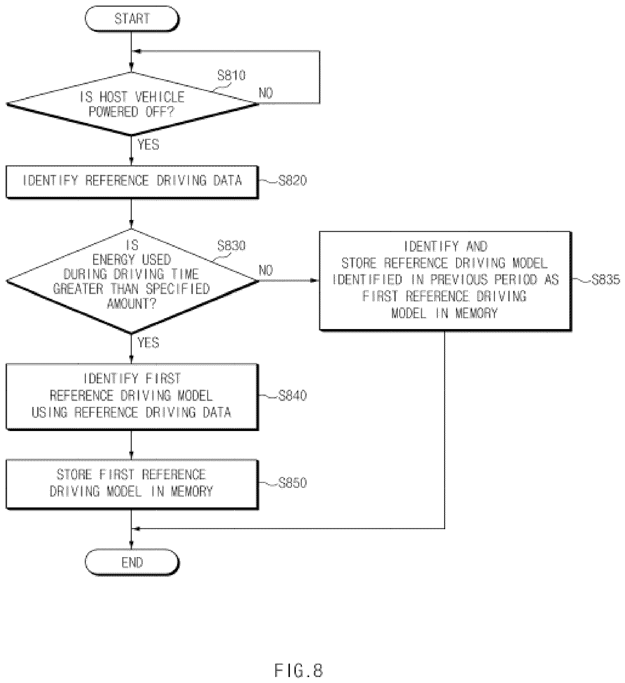

According to FIG. 5 and FIG. 6 above, in an exemplary embodiment of the present disclosure, an calendar aging model may be identified while a vehicle is driving and a driving durability mode may be identified while the vehicle is abandoned, whereas both of a reference abandonment model (or a reference calendar aging model) according to FIG. 7 and a reference driving mode (or a reference driving durability model) according to FIG. 8 may be determined (or identified) while the vehicle is abandoned.

According to an exemplary embodiment of the present disclosure, in S710, the vehicle battery control apparatus may identify whether a host vehicle is powered off.

For example, the vehicle battery control apparatus may identify whether the vehicle ends driving and is powered off.

For example, when it is identified that the host vehicle is powered off (or when it is identified that the host vehicle ends driving and is powered off) (e.g., S710 - YES), the vehicle battery control apparatus may perform S720.

For example, when it is identified that the host vehicle is not powered off (or when it is identified that the host vehicle is driving) (e.g., S710 - NO), the vehicle battery control apparatus may repeatedly perform S710. The present case may be a situation in which the host vehicle continues driving. At the instant time, the vehicle battery control apparatus may perform an operation of storing driving durability data according to FIG. 5 described above and/or an operation of determining (or identifying) a first abandonment model (or a first calendar aging model) corresponding to an nth period using an calendar aging model identified in a driving period identified in an n-1th period.

According to an exemplary embodiment of the present disclosure, in S720, the vehicle battery control apparatus may identify reference abandonment data.

For example, the reference abandonment data may include at least one of an abandonment time until the host vehicle starts to drive, a state of charge (SOC) value of the battery at a time point when the host vehicle is abandoned, or a battery temperature at each of the time point when the host vehicle is abandoned and the time point when the host vehicle starts to drive, or any combination thereof.

For example, the reference abandonment data may include at least one predetermined constant value to generate a reference model optimized by an experiment.

According to an exemplary embodiment of the present disclosure, in S730, the vehicle battery control apparatus may identify whether the abandonment time is greater than a predetermined time (e.g., 60 minutes).

For example, when the abandonment time is greater than the predetermined time (e.g., S730 - YES), the vehicle battery control apparatus may perform S740.

For example, when the abandonment time is less than or equal to the predetermined time (e.g., S730 - NO), the vehicle battery control apparatus may perform S735.

According to an exemplary embodiment of the present disclosure, in S735, the vehicle battery control apparatus may identify and store a reference abandonment model identified in a previous period as a first reference abandonment model in a memory.

In other words, assuming that the abandonment time period as the host vehicle is powered off in S710 is an nth abandonment time period, the vehicle battery control apparatus may identify and store an existing abandonment model identified in an abandonment time period (e.g., the n-1th abandonment time period) immediately before the nth abandonment time period as the first abandonment model in the memory, when the abandonment time is less than or equal to the predetermined time.

According to an exemplary embodiment of the present disclosure, in S740, the vehicle battery control apparatus may identify the first reference abandonment model using the reference abandonment data.

For example, the vehicle battery control apparatus may identify information related to a degradation state of the battery based on a difference between reference data identified using at least one of the first reference abandonment model, the reference abandonment data, the abandonment time, or an SOC value of the battery at the abandonment time point, or any combination thereof and degradation data identified using an calendar aging model.

For example, the vehicle battery control apparatus may newly determine (or identify) a first reference abandonment model, which is distinguished from an existing reference abandonment model (e.g., a reference abandonment model in the n-1th abandonment time period) and corresponds to the nth abandonment time period, using at least one of the existing reference abandonment model, the calendar aging data, the calendar aging model, or the reference durability data, or any combination thereof.

According to an exemplary embodiment of the present disclosure, in S750, the vehicle battery control apparatus may store the first reference abandonment model in the memory.

For example, the memory may be a non-volatile memory. Thus, even when the vehicle is powered off and switches to an on-state, the vehicle battery control apparatus may read pieces of data stored before the vehicle is powered off from the memory.

FIG. 8 is a flowchart of a vehicle battery control method according to an exemplary embodiment of the present disclosure.

According to an exemplary embodiment of the present disclosure, a vehicle battery control apparatus (e.g., a vehicle battery control apparatus 100 of FIG. 1) may perform operations included in FIG. 8. For example, at least some of components (e.g., a memory 120, a controller 130, and/or a display 140 of FIG. 1) included in the vehicle battery control apparatus may be configured to perform the operations of FIG. 8.

Operations in S810 to S850 in an exemplary embodiment below may be sequentially performed, but are not necessarily sequentially performed. For example, an order of the respective operations may be changed, and at least two operations may be performed in parallel. Furthermore, contents, which correspond to or are duplicated with the contents described above in conjunction with FIG. 8, may be briefly described or omitted.

According to FIG. 5 and FIG. 6 above, in an exemplary embodiment of the present disclosure, an calendar aging model may be identified while a vehicle is driving and a driving durability mode may be identified while the vehicle is abandoned, whereas both of a reference abandonment model (or a reference calendar aging model) according to FIG. 7 and a reference driving mode (or a reference driving durability model) according to FIG. 8 may be determined (or identified) while the vehicle is abandoned.

According to an exemplary embodiment of the present disclosure, in S810, the vehicle battery control apparatus may identify whether a host vehicle is powered off.

For example, the vehicle battery control apparatus may identify whether the vehicle ends driving and is powered off.

For example, when it is identified that the host vehicle is powered off (or when it is identified that the host vehicle ends driving and is powered off) (e.g., S810 - YES), the vehicle battery control apparatus may perform S820.

For example, when it is identified that the host vehicle is not powered off (or when it is identified that the host vehicle is driving) (e.g., S810 - NO), the vehicle battery control apparatus may repeatedly perform S810. The present case may be a situation in which the host vehicle continues driving. At the instant time, the vehicle battery control apparatus may perform an operation of storing driving durability data according to FIG. 5 described above and/or an operation of determining (or identifying) a first abandonment model (or a first calendar aging model) corresponding to an nth period using an calendar aging model corresponding to an n-1th period.

According to an exemplary embodiment of the present disclosure, in S820, the vehicle battery control apparatus may identify reference driving data.

For example, the reference driving data may include at least one of energy used until the host vehicle is powered off, a current used while the host vehicle is driving, or an average battery temperature while driving, or any combination thereof.

For example, the reference driving data may include at least one predetermined constant value to generate a reference model optimized by an experiment.

According to an exemplary embodiment of the present disclosure, in S830, the vehicle battery control apparatus may identify whether the energy used during the driving time is greater than a specified amount (e.g., 0.5 Wh).

For example, when the energy used during the driving time is greater than the specified amount (e.g., S830 - YES), the vehicle battery control apparatus may perform S840.

For example, when the energy used during the driving time is less than or equal to the specified amount (e.g., S830 - NO), the vehicle battery control apparatus may perform S835.

According to an exemplary embodiment of the present disclosure, in S835, the vehicle battery control apparatus may be configured to determine (or identify) and store a reference driving model identified in a previous period as a first reference driving model in a memory.

In other words, assuming that the driving period as the host vehicle is powered off in S810 is an nth driving period, the vehicle battery control apparatus may be configured to determine (or identify) and store an existing reference driving model identified in a driving period (e.g., the n-1th driving period) immediately before the nth driving period as the first reference driving model in the memory, when the energy used during the driving time is less than or equal to the specified amount.

According to an exemplary embodiment of the present disclosure, in S840, the vehicle battery control apparatus may identify the first reference driving model using the reference driving data.

For example, the vehicle battery control apparatus may identify information related to a degradation state of the battery based on a difference between reference data identified using at least one of the first reference driving model, the reference driving data, the driving time, a value about a battery current (e.g., an RMS value of current) while driving, or an average battery temperature while driving, or any combination thereof and degradation data identified using the driving durability model.

For example, the vehicle battery control apparatus may newly determine (or identify) a first reference driving model, which is distinguished from an existing reference driving model (e.g., a reference driving model in the n-1th driving period) and corresponds to the nth driving period, using at least one of the existing reference driving model, the driving durability data, the driving durability model, or the reference driving data, or any combination thereof.

According to an exemplary embodiment of the present disclosure, in S750, the vehicle battery control apparatus may store the first reference driving model in the memory.

For example, the memory may be a non-volatile memory. Thus, even when the vehicle is powered off and switches to an on-state, the vehicle battery control apparatus may read pieces of data stored before the vehicle is powered off from the memory.

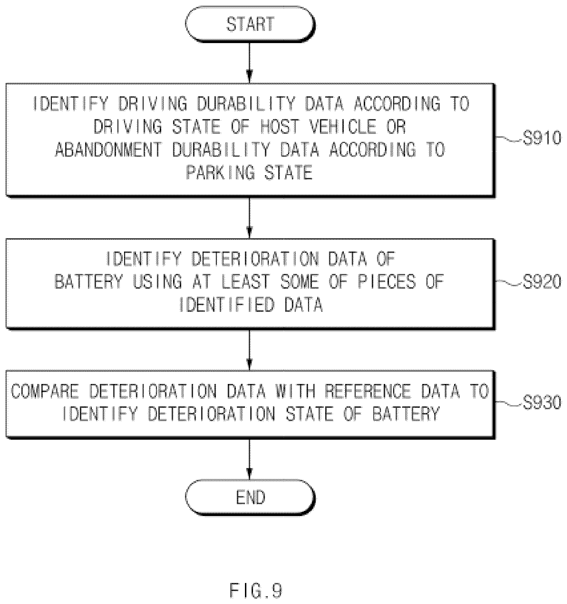

FIG. 9 is a flowchart of a vehicle battery control method according to an exemplary embodiment of the present disclosure.

According to an exemplary embodiment of the present disclosure, a vehicle battery control apparatus (e.g., a vehicle battery control apparatus 100 of FIG. 1) may perform operations included in FIG. 9. For example, at least some of components (e.g., a memory 120, a controller 130, and/or a display 140 of FIG. 1) included in the vehicle battery control apparatus may be configured to perform the operations of FIG. 9.

Operations in S910 to S930 in an exemplary embodiment below may be sequentially performed, but are not necessarily sequentially performed. For example, an order of the respective operations may be changed, and at least two operations may be performed in parallel. Furthermore, contents, which correspond to or are duplicated with the contents described above in conjunction with FIG. 9, may be briefly described or omitted.

According to an exemplary embodiment of the present disclosure, in S910, a controller may identify driving durability data according to a driving state of a host vehicle or calendar aging data according to a parking state of the host vehicle.

For example, the calendar aging data may include at least one of an abandonment time until the host vehicle starts to drive, a state of charge (SOC) value of the battery at a time point when the host vehicle is abandoned, or a battery temperature at each of the time point when the host vehicle is abandoned and the time point when the host vehicle starts to drive, or any combination thereof.

For example, the driving durability data may include at least one of energy used until the host vehicle is powered off, a current used while the host vehicle is driving, or an average battery temperature while driving, or any combination thereof.

According to an exemplary embodiment of the present disclosure, in S920, the controller may identify degradation data of the battery using at least some of the pieces of identified data.

According to an exemplary embodiment of the present disclosure, in S930, the controller may compare the degradation data and reference data to identify a degradation state of the battery.

For example, the controller may identify a degradation state including a degradation degree of the battery, based on a difference between the degradation data and the reference data.

For example, the controller may display a battery state notification and/or a battery management guide about the identified degradation state to a user on a display.

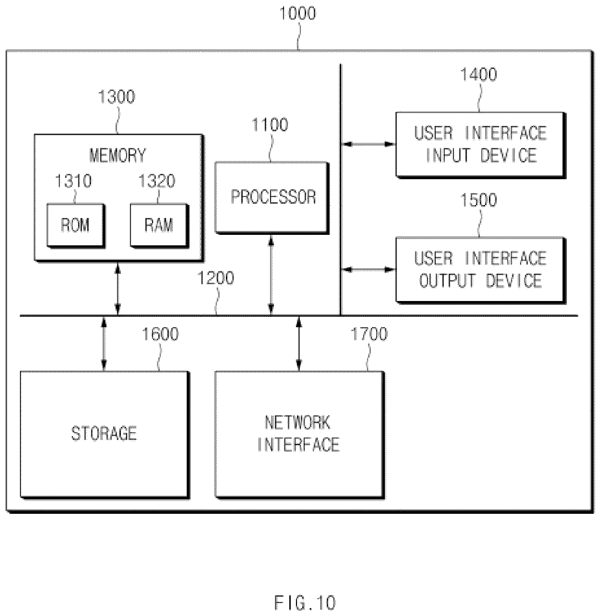

FIG. 10 illustrates a computing system about a vehicle battery control method according to an exemplary embodiment of the present disclosure.

Referring to FIG. 10, a computing system 1000 about the vehicle battery control method may include at least one processor 1100, a memory 1300, a user interface input device 1400, a user interface output device 1500, storage 1600, and a network interface 1700, which are connected to each other via a bus 1200.

The processor 1100 may be a central processing unit (CPU) or a semiconductor device that processes instructions stored in the memory 1300 and/or the storage 1600. The memory 1300 and the storage 1600 may include various types of volatile or non-volatile storage media. For example, the memory 1300 may include a Read-Only Memory (ROM) 1310 and a Random Access Memory (RAM) 1320.

Accordingly, the operations of the method or algorithm described in connection with the exemplary embodiments included in the specification may be directly implemented with a hardware module, a software module, or a combination of the hardware module and the software module, which is executed by the processor 1100. The software module may reside on a storage medium (that is, the memory 1300 and/or the storage 1600) such as a RAM, a flash memory, a ROM, an EPROM, an EEPROM, a register, a hard disc, a removable disk, and a CD-ROM.

The exemplary storage medium may be coupled to the processor 1100. The processor 1100 may read out information from the storage medium and may write information in the storage medium. Alternatively, the storage medium may be integrated with the processor 1100. The processor and the storage medium may reside in an application specific integrated circuit (ASIC). The ASIC may reside within a user terminal. In another case, the processor and the storage medium may reside in the user terminal as separate components.

A description will be given of effects of the vehicle battery control apparatus and the method thereof according to an exemplary embodiment of the present disclosure.

According to at least one of embodiments of the present disclosure, the vehicle battery control apparatus may more accurately and rapidly identify information related to a degradation degree of the battery, based on a difference between the degradation degree of the battery, which is identified by a durability model based on real-time driving data of the vehicle and the degradation degree of the battery, which is identified by a reference durability model based on predefined parameters.

Furthermore, according to at least one of embodiments of the present disclosure, the vehicle battery control apparatus may provide the user with a user interface including a battery state notification and/or a battery management guide about the degradation degree of the battery in real time.

Furthermore, according to at least one of embodiments of the present disclosure, the vehicle battery control apparatus may change and display a battery state notification in real time based on a driving habit of the user or the like and may guide the user to efficiently use the battery.

Furthermore, according to at least one of embodiments of the present disclosure, the vehicle battery control apparatus may sequentially display a battery management guide corresponding to a parameter having relatively more influence on degradation in the battery.

Furthermore, according to at least one of embodiments of the present disclosure, the vehicle battery control apparatus may display various parameters having an influence on degradation in the battery so that the user is configured to visually and audibly identify them, thus helping the user maintain a good driving habit from a battery management perspective and increasing the performance of the battery or a usage duration of the battery.

Furthermore, various effects ascertained directly or indirectly through the present disclosure may be provided.

Hereinabove, although the present disclosure has been described with reference to exemplary embodiments and the accompanying drawings, the present disclosure is not limited thereto, but may be variously modified and altered by those skilled in the art to which the present disclosure pertains without departing from the spirit and scope of the present disclosure claimed in the following claims.

In various exemplary embodiments of the present disclosure, each operation described above may be performed by a control device, and the control device may be configured by a plurality of control devices, or an integrated single control device.

In various exemplary embodiments of the present disclosure, the memory and the processor may be provided as one chip, or provided as separate chips.

In various exemplary embodiments of the present disclosure, the scope of the present disclosure includes software or machine-executable commands (e.g., an operating system, an application, firmware, a program, etc.) for enabling operations according to the methods of various embodiments to be executed on an apparatus or a computer, a non-transitory computer-readable medium including such software or commands stored thereon and executable on the apparatus or the computer.

In various exemplary embodiments of the present disclosure, the control device may be implemented in a form of hardware or software, or may be implemented in a combination of hardware and software.

Furthermore, the terms such as "unit", "module", etc. included in the specification mean units for processing at least one function or operation, which may be implemented by hardware, software, or a combination thereof.

In an exemplary embodiment of the present disclosure, the vehicle may be referred to as being based on a concept including various means of transportation. In some cases, the vehicle may be interpreted as being based on a concept including not only various means of land transportation, such as cars, motorcycles, trucks, and buses, that drive on roads but also various means of transportation such as airplanes, drones, ships, etc.

For convenience in explanation and accurate definition in the appended claims, the terms "upper", "lower", "inner", "outer", "up", "down", "upwards", "downwards", "front", "rear", "back", "inside", "outside", "inwardly", "outwardly", "interior", "exterior", "internal", "external", "forwards", and "backwards" are used to describe features of the exemplary embodiments with reference to the positions of such features as displayed in the figures. It will be further understood that the term "connect" or its derivatives refer both to direct and indirect connection.

The term "and/or" may include a combination of a plurality of related listed items or any of a plurality of related listed items. For example, "A and/or B" includes all three cases such as "A", "B", and "A and B".

In the present specification, unless stated otherwise, a singular expression includes a plural expression unless the context clearly indicates otherwise.

In exemplary embodiments of the present disclosure, "at least one of A and B" may refer to "at least one of A or B" or "at least one of combinations of at least one of A and B". Furthermore, "one or more of A and B" may refer to "one or more of A or B" or "one or more of combinations of one or more of A and B".

In the exemplary embodiment of the present disclosure, it should be understood that a term such as "include" or "have" is directed to designate that the features, numbers, steps, operations, elements, parts, or combinations thereof described in the specification are present, and does not preclude the possibility of addition or presence of one or more other features, numbers, steps, operations, elements, parts, or combinations thereof.

According to an exemplary embodiment of the present disclosure, components may be combined with each other to be implemented as one, or some components may be omitted.

The foregoing descriptions of specific exemplary embodiments of the present disclosure have been presented for purposes of illustration and description. They are not intended to be exhaustive or to limit the present disclosure to the precise forms disclosed, and obviously many modifications and variations are possible in light of the above teachings. The exemplary embodiments were chosen and described in order to explain certain principles of the invention and their practical application, to enable others skilled in the art to make and utilize various exemplary embodiments of the present disclosure, as well as various alternatives and modifications thereof. It is intended that the scope of the present disclosure be defined by the Claims appended hereto and their equivalents.

400: DISPLAY
411: FIRST USER INTERFACE
412: SECOND USER INTERFACE
413: THIRD USER INTERFACE
414: FOURTH USER INTERFACE
415: FIFTH USER INTERFACE
416: SIXTH USER INTERFACE
417: SEVENTH USER INTERFACE

**Claims**

1. A vehicle battery control apparatus, comprising:

   a memory storing at least one instruction; and
   a controller operatively connected to the memory,
   wherein the at least one instruction executed by the controller, is configured to cause the vehicle battery control apparatus to:

      obtain at least one of driving durability data according to a driving state of a host vehicle or calendar aging data according to a parking state of the host vehicle, or any combination thereof;
      obtain degradation data of a battery of the host vehicle using at least some of the driving durability data or the calendar aging data, or the any combination thereof; and
      compare reference data identified based on a predetermined reference model with the degradation data to determine a degradation state of the battery.

2. The vehicle battery control apparatus of claim 1, wherein the at least one instruction executed by the controller is configured to cause the vehicle battery control apparatus to:

accumulate and store the driving durability data according to the driving state while driving in the memory, when the host vehicle starts to drive; and

identify the degradation data of the battery, based on at least one of the calendar aging data according to the parking state, the calendar aging data being stored in the memory before the host vehicle starts to drive, or an existing calendar aging model, or any combination thereof.

3. The vehicle battery control apparatus of claim 2, wherein the at least one instruction executed by the controller is configured to cause the vehicle battery control apparatus to:

identify the degradation data of the battery based on at least one of the existing calendar aging model corresponding to an abandonment time period before the host vehicle starts to drive or the calendar aging data, or any combination thereof and store a first calendar aging model determined using the calendar aging data, the degradation data, and the existing calendar aging model in the memory, upon concluding that an abandonment time before the host vehicle starts to drive is greater than a predetermined time; and

determine and store the existing calendar aging model as the first calendar aging model in the memory, upon concluding that the abandonment time is less than or equal to the predetermined time.

4. The vehicle battery control apparatus of claim 1, wherein the calendar aging data includes at least one of an abandonment time until the host vehicle starts to drive, a state of charge (SOC) value of the battery at a time point when the host vehicle is abandoned, or a battery temperature at each of the time point when the host vehicle is abandoned and a time point when the host vehicle starts to drive, or any combination thereof.

5. The vehicle battery control apparatus of claim 1, wherein the at least one instruction executed by the controller is configured to cause the vehicle battery control apparatus to:

accumulate and store the calendar aging data according to the parking state during abandonment in the memory, when the host vehicle ends driving and is powered off; and

identify the degradation data of the battery, based on at least one of the driving durability data according to the driving state, the driving durability data being stored in the memory before the host vehicle is powered off, or an existing driving durability model, or any combination thereof.

6. The vehicle battery control apparatus of claim 5, wherein the at least one instruction executed by the controller is configured to cause the vehicle battery control apparatus to:

identify the degradation data of the battery based on at least one of the existing driving durability model identified in a driving period before the host vehicle is powered off or the driving durability data, or any combination thereof and store a first driving durability model identified using the driving durability data, the degradation data, and the existing driving durability model in the memory, upon concluding that energy used while driving before the host vehicle is powered off is greater than a specified amount; and

determine and store the existing driving durability model as the first driving durability model in the memory, upon concluding that the energy is less than or equal to the specified amount.

7. The vehicle battery control apparatus of claim 1, wherein the driving durability data includes at least one of energy used until the host vehicle is powered off, a current used while the host vehicle is driving, or an average battery temperature while the host vehicle is driving, or any combination thereof.

8. The vehicle battery control apparatus of claim 1, wherein the at least one instruction executed by the controller is configured to cause the vehicle battery control apparatus to:

determine the reference model based on reference durability data about at least one of a current, a temperature of the battery, or an SOC value, or any combination thereof, in response that the host vehicle ends driving and is powered off; and

compare the reference data identified by inputting at least one of at least a portion of the driving durability data or at least a portion of the calendar aging data, or any combination thereof to the reference model with the degradation data to identify the degradation state of the battery.

9. The vehicle battery control apparatus of claim 8, further comprising:

a display operatively connected to the controller,

wherein the at least one instruction executed by the controller is configured to cause the vehicle battery control apparatus to:

identify a score about a degradation degree of the battery, based on a difference between the reference data and the degradation data; and

display at least one of a predetermined battery state notification corresponding to a magnitude of the score among a plurality of battery state notifications or a battery operation guide identified based on a battery usage history, or any combination thereof, using the display.

10. The vehicle battery control apparatus of claim 9, wherein the at least one instruction executed by the controller is configured to cause the vehicle battery control apparatus to:

display the battery operation guide including at least one of a ratio between normal charge and quick charge, a ratio between normal driving and driving at rapid acceleration and deceleration, an amount of average charging of the battery while parked, or an average temperature of the battery while driving, or any combination thereof.

11. A vehicle battery control method, comprising:

obtaining, by a controller, at least one of driving durability data according to a driving state of a host vehicle or calendar aging data according to a parking state of the host vehicle, or any combination thereof;

obtaining, by the controller, degradation data of a battery of the host vehicle using at least some of the driving durability data or the calendar aging data, or the any combination thereof; and

comparing, by the controller, reference data identified based on a predetermined reference model with the degradation data to determine a degradation state of the battery.

12. The vehicle battery control method of claim 11, wherein the identifying of the degradation data by the controller includes:

accumulating and storing, by the controller, the driving durability data according to the driving state while driving in a memory operatively connected to the controller, when the host vehicle starts to drive; and

identifying, by the controller, the degradation data of the battery, based on at least one of the calendar aging data according to the parking state, the calendar aging data being stored in the memory before the host vehicle starts to drive, or an existing calendar aging model, or any combination thereof.

13. The vehicle battery control method of claim 12, further including:

identifying, by the controller, the degradation data of the battery based on at least one of the existing calendar aging model corresponding to an abandonment time period before the host vehicle starts to drive or the calendar aging data, or any combination thereof and storing, by the controller, a first calendar aging model determined using the calendar aging data, the degradation data, and the existing calendar aging model in the memory, upon concluding that an abandonment time before the host vehicle starts to drive is greater than a predetermined time; and

determining and storing, by the controller, the existing calendar aging model as the first calendar aging model in the memory, upon concluding that the abandonment time is less than or equal to the predetermined time.

14. The vehicle battery control method of claim 11, wherein the calendar aging data includes at least one of an abandonment time until the host vehicle starts to drive, a state of charge (SOC) value of the battery at a time point when the host vehicle is abandoned, or a battery temperature at each of the time point when the host vehicle is abandoned and a time point when the host vehicle starts to drive, or any combination thereof.

15. The vehicle battery control method of claim 11, wherein the identifying of the degradation data by the controller includes:

accumulating and storing, by the controller, the calendar aging data according to the parking state during abandonment in the memory, in response that the host vehicle ends driving and is powered off; and

identifying the degradation data of the battery, based on at least one of the driving durability data according to the driving state, the driving durability data being stored in the memory before the host vehicle is powered off, an existing driving durability model, or any combination thereof.

VEHICLE BATTERY CONTROL APPARATUS
100

MEMORY
120

CONTROLLER
130

DISPLAY
140

FIG.1

BATTERY
210

CALCULATION DEVICE
220

DRIVING DURABILITY
INPUT DATA CALCULATION
DEVICE 221

ABANDONMENT DURABILITY
INPUT DATA CALCULATION
DEVICE 225

DRIVING DURABILITY
OUTPUT DATA CALCULATION
DEVICE 223

ABANDONMENT DURABILITY
OUTPUT DATA CALCULATION
DEVICE 227

AVN DISPLAY VARIABLE
CALCULATION DEVICE
229

DISPLAY
230

BATTERY USAGE
STATISTICS INFORMATION
232

BATTERY STATE
NOTIFICATION AND
BATTERY OPERATION GUIDE
234

FIG.2

```
                          ┌──────────────┐
                          │    START     │
                          └──────┬───────┘
                                 │
                                 ▼
                         ╱╲ ─────────── S310
            ┌─────╱              ╲─────┐
       NO   │     ╲    DOES      ╱     │  YES
       ┌────┘      ╲ HOST VEHICLE START╱
       │            ╲  TO DRIVE?  ╱
       │             ╲         ╱
       │              ╲     ╱
       ▼               ╲ ╱                          │
┌──────────────────┐                        ┌──────────────────┐
│ IDENTIFY DRIVING │                        │ IDENTIFY ABANDONMENT│
│ DURABILITY MODEL AND│─ S324               │ DURABILITY MODEL AND│─ S322
│ STORE ABANDONMENT│                        │   STORE DRIVING   │
│ DURABILITY DATA  │                        │ DURABILITY DATA   │
└────────┬─────────┘                        └─────────┬─────────┘
         │                                            │
         └─────────────────┬──────────────────────────┘
                           ▼
              ┌────────────────────────────┐
              │     IDENTIFY REFERENCE      │
              │ DURABILITY MODEL BASED ON   │─ S330
              │ GUARANTEED DRIVING DISTANCE │
              └──────────────┬──────────────┘
                             ▼
              ┌────────────────────────────┐
              │ IDENTIFY BATTERY STATE BASED ON│
              │      COMPARISON BETWEEN     │─ S340
              │      AT LEAST ONE MODEL     │
              └──────────────┬──────────────┘
                             ▼
              ┌────────────────────────────┐
              │UPDATE BATTERY STATE NOTIFICATION│
              │   AND/OR BATTERY MANAGEMENT │─ S350
              │ GUIDE BASED ON IDENTIFIED STATE│
              └──────────────┬──────────────┘
                             ▼
                      ┌──────────────┐
                      │     END      │
                      └──────────────┘
```

FIG.3

400

411     415     417

○ Electric Vehicle     ○ (Indicator) 10:34 AM

⑥ (GOOD) ⑦ HIGH BATTERY CAPACITY DOES NOT HELP MAINTAIN BATTERY PERFORMANCE WHEN NOT DRIVING FOR A LONG TIME. WE RECOMMEND CHARGING AROUND 50-80%.

Electricity Use

EV Economy History

412 — BATTERY USAGE STATISTICS INFORMATION

BATTERY CARE GUIDE

① CHARGING    ▨ SLOW    ☐ QUICK

② DRIVING    ▨ CITY    ☐ HIGH SPEED

⑤ SMOOTH DRIVING    GOOD

③ BATTERY CAPACITY WHILE PARKED    XX %    XX %

④ BATTERY TEMPERATURE WHILE DRIVING    XX ℃    XX ℃

416

413 — ↺   ⌂   ≡   | Icon (EV Home) | Icon (Energy Info) | Icon (Charging) | Icon (Settings) | ☒ Track 1 - Artist Name

414

FIG.4

START

IS HOST VEHICLE POWERED ON? S510

NO

YES

IDENTIFY ABANDONMENT DURABILITY DATA ~S520

IS ABANDONMENT TIME GREATER THAN SPECIFIED TIME? S530

NO

IDENTIFY AND STORE ABANDONMENT MODEL MODEL IN MEMORY PREVIOUS PERIOD AS FIRST ABANDONMENT MODEL IN MEMORY ~S535

YES

IDENTIFY FIRST ABANDONMENT MODEL USING ABANDONMENT DURABILITY DATA ~S540

STORE FIRST ABANDONMENT MODEL IN MEMORY ~S550

END

FIG.5

START

S610
IS HOST VEHICLE POWERED OFF?
NO
YES

IDENTIFY DRIVING DURABILITY DATA ~S620

S630
IS ENERGY USED DURING DRIVING TIME GREATER THAN SPECIFIED AMOUNT?
NO
YES

IDENTIFY AND STORE DRIVING MODEL IDENTIFIED IN PREVIOUS PERIOD AS FIRST DRIVING MODEL IN MEMORY ~S635

IDENTIFY FIRST DRIVING MODEL USING DRIVING DURABILITY DATA ~S640

STORE FIRST DRIVING MODEL IN MEMORY ~S650

END

FIG.6

FIG.7

START

S810

IS HOST VEHICLE POWERED OFF? —— NO

YES

IDENTIFY REFERENCE DRIVING DATA —S820

IS ENERGY USED DURING DRIVING TIME GREATER THAN SPECIFIED AMOUNT? — S830 —— NO

IDENTIFY AND STORE REFERENCE DRIVING MODEL IDENTIFIED IN PREVIOUS PERIOD AS FIRST REFERENCE DRIVING MODEL IN MEMORY —S835

YES

IDENTIFY FIRST REFERENCE DRIVING MODEL USING REFERENCE DRIVING DATA —S840

STORE FIRST REFERENCE DRIVING MODEL IN MEMORY —S850

END

FIG.8

START

IDENTIFY DRIVING DURABILITY DATA ACCORDING TO
DRIVING STATE OF HOST VEHICLE OR
ABANDONMENT DURABILITY DATA ACCORDING TO
PARKING STATE — S910

IDENTIFY DETERIORATION DATA OF
BATTERY USING AT LEAST SOME OF PIECES OF
IDENTIFIED DATA — S920

COMPARE DETERIORATION DATA WITH REFERENCE DATA TO
IDENTIFY DETERIORATION STATE OF BATTERY — S930

END

FIG.9

1000

1300

1100

1400

MEMORY

1310        1320

ROM         RAM

PROCESSOR

USER INTERFACE
INPUT DEVICE

1500

USER INTERFACE
OUTPUT DEVICE

1200

1600

1700

STORAGE

NETWORK
INTERFACE

FIG.10

Europäisches
Patentamt

European
Patent Office

Office européen
des brevets

# EUROPEAN SEARCH REPORT

Application Number

EP 24 19 2939

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/317690 A1 (FUJITA TAKESHI [JP] ET AL) 28 November 2013 (2013-11-28) * abstract * * paragraphs [0007] - [0009], [0014] - [0028], [0030] - [0037], [0044] - [0053]; figures 1-4 * | 1-15 | INV. B60L3/00 B60L3/12 B60L53/10 B60L58/12 B60L58/16 B60W50/04 |
| X | US 2023/278463 A1 (POLONI TOMAS [SK] ET AL) 7 September 2023 (2023-09-07) * abstract * * paragraphs [0004] - [0023], [0042] - [0045], [0047] - [0073], [0076] - [0080]; figures 1-13D * | 1-15 | G01R31/387 G01R31/392 H01M10/48 H01M10/625 H02J7/00 |
| X | US 2023/182575 A1 (KIM HYUN [KR] ET AL) 15 June 2023 (2023-06-15) * abstract * * paragraphs [0006] - [0030], [0036] - [0039], [0068] - [0084], [0101] - [0134], [0140] - [0150], [0158] - [0191], [0199] - [0206]; figures 1-10 * | 1-15 | |
| X | US 2018/050601 A1 (KATANODA TOMOYA [JP]) 22 February 2018 (2018-02-22) * abstract * * paragraphs [0007] - [0009], [0023] - [0029], [0038] - [0041], [0046] - [0062], [0070] - [0094], [0100] - [0119]; figures 1-10 * | 1-9, 11-15 | |

TECHNICAL FIELDS SEARCHED (IPC)

B60L
G01R
H02J
H01M
B60W

The present search report has been drawn up for all claims

| Place of search | Date of completion of the search | Examiner |
|---|---|---|
| The Hague | 22 January 2025 | Molnar, Sabinus |

EPO FORM 1503 03.82 (P04C01)

**EP 4 523 943 A1**

## ANNEX TO THE EUROPEAN SEARCH REPORT
## ON EUROPEAN PATENT APPLICATION NO.

EP 24 19 2939

22-01-2025

| Patent document cited in search report | Publication date | Patent family member(s) | | Publication date |
|---|---|---|---|---|
| US 2013317690 A1 | 28-11-2013 | BR | 112013011414 A2 | 02-08-2016 |
| | | CN | 103201133 A | 10-07-2013 |
| | | EP | 2639096 A1 | 18-09-2013 |
| | | JP | 5545373 B2 | 09-07-2014 |
| | | JP | WO2012063606 A1 | 12-05-2014 |
| | | KR | 20130097787 A | 03-09-2013 |
| | | MY | 158124 A | 30-08-2016 |
| | | PH | 12013500871 A1 | 08-02-2017 |
| | | RU | 2013126407 A | 20-12-2014 |
| | | US | 2013317690 A1 | 28-11-2013 |
| | | WO | 2012063606 A1 | 18-05-2012 |
| US 2023278463 A1 | 07-09-2023 | CN | 116125324 A | 16-05-2023 |
| | | EP | 4239351 A2 | 06-09-2023 |
| | | US | 2023278463 A1 | 07-09-2023 |
| US 2023182575 A1 | 15-06-2023 | CN | 114746892 A | 12-07-2022 |
| | | EP | 4060599 A1 | 21-09-2022 |
| | | EP | 4424546 A2 | 04-09-2024 |
| | | EP | 4424547 A2 | 04-09-2024 |
| | | EP | 4424548 A2 | 04-09-2024 |
| | | JP | 7381742 B2 | 15-11-2023 |
| | | JP | 7592827 B2 | 02-12-2024 |
| | | JP | 2023501318 A | 18-01-2023 |
| | | JP | 2024001341 A | 09-01-2024 |
| | | KR | 20210149626 A | 09-12-2021 |
| | | KR | 20250005927 A | 10-01-2025 |
| | | US | 2023182575 A1 | 15-06-2023 |
| | | WO | 2021246788 A1 | 09-12-2021 |
| US 2018050601 A1 | 22-02-2018 | CN | 107757391 A | 06-03-2018 |
| | | JP | 2018029430 A | 22-02-2018 |
| | | US | 2018050601 A1 | 22-02-2018 |

EPO FORM P0459

For more details about this annex : see Official Journal of the European Patent Office, No. 12/82